# EUROPEAN PATENT APPLICATION

(11) **EP 1 376 230 A1**
(43) Date of publication of application: **02.01.2004**
(21) Application number: 02700770.7
(22) Date of filing: 26.02.2002
(51) Int. Cl.: G03F 7/039, H01L 21/027

(54) **FINE PATTERN FORMING METHOD**

(30) Priority: 09.03.2001 JP 2001067674
(71) Applicant: Semiconductor Leading Edge Technologies, Inc., Ibaraki-ken, 305-0053 (JP); Daikin Industries, Ltd., Osaka-shi, Osaka 530-8323 (JP)
(72) Inventor: NAITO, Takuya, c/o SEMICON. LEADING EDGE TECH. INC, Tsukuba-shi , Ibaraki 305-0053 (JP); ISHIKAWA, Seiichi, c/o SEMICON LDNG. EDGE TECH INC, Tsukuba-shi, Ibaraki 305-0053 (JP); TORIUMI, Minoru, c/o Yodogawa-seisakusho, DAIKIN, Settsu-shi, Osaka 566-8585 (JP); MIYOSHI, Seiro, c/o SEMICON. LEADING EDGE TECH INC, Tsukuba-shi, Ibaraki 305-0053 (JP); YAMAZAKI, Tamio, c/o SEMICON LEADING EDGE TECH INC, Tsukuba-shi, Ibaraki 305-0053 (JP); WATANABE, Manabu c/o SEMICON LEADING EDGE TECH INC, Tsukuba-shi, Ibaraki 305-0053 (JP); ITANI, Toshiro, c/o SEMICON LEADING EDGE TECH INC., Tsukuba-shi, Ibaraki 305-0053 (JP); ARAKI, Takayuki, c/o DAIKIN INDUSTRIES LTD., Settsu-shi, OsaKA 566-8585 (JP); ISHIKAWA, Takuji, c/o DAIKIN INDUSTRIES LTD., Settsu-shi, Osaka 566-8585 (JP); KOH, Meiten, c/o DAIKIN INDUSTRIES LTD., Settsu-shi, Osaka 566-8585 (JP)
(74) Representative: HOFFMANN - EITLE
(86) International application number: PCT/JP2002/001697
(87) International publication number: WO 2002/073316

(57) **Abstract**

There is provided a method of forming a fine resist pattern in which a highly practicable photo-sensitive composition obtained from a material having a high transparency against an exposure light having a short wavelength such as F₂ excimer laser beam is used as a resist, and the method of forming a fine resist pattern comprises a step for forming a photo-sensitive layer on a substrate or on a given layer on a substrate using a photo-sensitive composition comprising at least a compound generating an acid by irradiation of light and a compound having fluorine atom in its molecular structure, a step for exposing by selectively irradiating a given area of said photo-sensitive layer with energy ray, a step for heat-treating the exposed photo-sensitive layer, and a step for forming a fine pattern by developing the heat-treated photo-sensitive layer to selectively remove the exposed portion or un-exposed portion of the photo-sensitive layer.

## Description

### TECHNICAL FIELD

The present invention relates to a method of fine pattern formation in production of semiconductor devices.

### BACKGROUND ART

Ultra fine fabrication is required for various electronic parts such as semiconductor integrated circuit, and a resist is widely used for a processing technology therefor. With the pursuit of multi functions and high density of electronic parts, ultra fine fabrication of a resist pattern to be formed is demanded. As the resist used for fabrication of such an ultra fine pattern, there are chemically amplifying resists disclosed in JP63-27829A, etc.

The chemically amplifying resists are broadly classified into a positive type resist and a negative type resist.

The positive type chemically amplifying resist is, for example, a three-component composition comprising an alkali-soluble resin, a dissolution inhibitor and an acid generator or a two-component composition comprising an alkali-soluble resin to which a group (dissolution-inhibiting group) having a dissolution-inhibiting effect is introduced and an acid generator. When the resist is in un-exposed state, solubility thereof in an alkali developing solution is inhibited by the dissolution-inhibiting group.

When the resist film formed on a substrate is irradiated with light, X-ray, high energy electron beam or the like, an acid generator is decomposed at the exposed portion and an acid is generated, and further when the resist film is subjected to heat-treating after the exposure, the acid acts as a catalyst to decompose the dissolution inhibitor. Therefore an intended pattern can be formed by dissolving and removing, with a developing solution, the exposed portion in which the dissolution inhibitor has been decomposed.

On the other hand, the negative type chemically amplifying resist is, for example, a composition comprising an acid generator, a compound having a substituent undergoing crosslinking by an acid and as case demands, an alkali-soluble resin. In the negative type resist, too, when the resist film formed on a substrate is irradiated with light, X-ray, high energy electron beam or the like, an acid is generated from the acid generator in the exposed portion like the above-mentioned positive type resist. When the resist film is subjected to heat-treating subsequently to the exposing, the acid accelerates crosslinking and therefore, solubility of the exposed portion in alkali is lowered. Therefore, by carrying out developing treatment, the thus crosslinked exposed portion remains and un-exposed portion is dissolved and removed to form a pattern.

For forming a pattern using such a resist, a reduction projection exposure system usually called a stepper is generally used as an exposure system. As a result of a recent remarkable progress of multi functions and high density of electronic parts, a further fine circuit is demanded, which makes it necessary to form a fine pattern.

In the above-mentioned exposure system, since a pattern fabrication is carried out by projecting an optical image on a substrate, a limit of resolution depends on a wavelength of light used for the exposing. For the fine fabrication, a wavelength of light source used for the exposing has been becoming shorter. It is a matter of certainty that in production of a device coming after a giga bit memory era, F₂ excimer laser having a wavelength of 157 nm will be mainly used as light source. Therefore, development of a chemically amplifying resist capable of forming a fine pattern using F₂ excimer laser as light source has already been initiated.

However materials which have been used for conventional resists have a large amount of absorption of F₂ excimer laser beam having a wavelength of 157 nm. When F₂ excimer laser beam is used for the exposing of a photo-sensitive composition prepared from such materials, sufficient amount of exposure beam does not reach the bottom of the resist. Therefore uniform exposing in the direction of a depth of the photo-sensitive composition formed on the substrate cannot be carried out, and it is difficult to enhance resolution.

The present invention was made to solve the mentioned problems, and an object of the present invention is to provide a method of forming a fine pattern using, as a resist, a highly practicable photo-sensitive composition obtained from a material having a high transparency against exposure light having a short wavelength such as F₂ excimer laser beam.

### DISCLOSURE OF INVENTION

The present invention relates to a method of forming a fine resist pattern comprising a step for forming a photo-sensitive layer on a substrate or on a given layer on a substrate by using a photo-sensitive composition comprising at least a compound generating an acid by irradiation of light and a component to be decomposed by an acid, a step for exposing by selectively irradiating a given area of the photo-sensitive layer with energy ray, a step for heat-treating the photo-sensitive layer after the exposing and a step for forming a fine pattern by developing the heat-treated photo-sensitive layer to selectively remove the exposed portion or un-exposed portion of the photo-sensitive layer. The component which is contained in the photo-sensitive composition and is decomposed by an acid is characterized by being a compound having fluorine atom in its molecular structure.

It is particularly preferable that the above-mentioned compound having fluorine atom is a fluorine-containing copolymer having a ring structure in its trunk chain and containing acid-labile functional groups which are converted to carboxyl due to action of an acid, and the fluorine-containing copolymer is represented by the formula (1):

-(M1)-(M2)-(M3)-(A1)- (1)

wherein the structural unit M 1 is a structural unit derived from an ethylenic monomer having 2 or 3 carbon atoms and at least one fluorine atom,
the structural unit M2 is a structural unit derived from a cyclic aliphatic unsaturated hydrocarbon which is copolymerizable with M 1 and may be subjected to replacing with fluorine atom,
the structural unit M3 is a structural unit represented by: 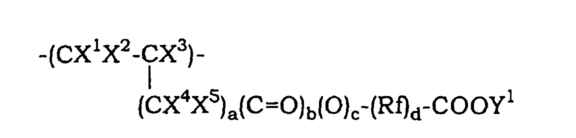 wherein Y¹ is an acid-labile functional group; X¹ and X² are the same or different and each is H or F; X³ is H, F, Cl, CH₃ or CF₃; X⁴ and X⁵ are the same or different and each is H, F or CF₃; Rf is a fluorine-containing alkylene group having 1 to 40 carbon atoms or a fluorine-containing alkylene group having 2 to 100 carbon atoms and ether bond; a is 0 or an integer of from 1 to 3; b, c and d are the same or different and each is 0 or 1,
the structural unit A1 is a structural unit derived from monomer copolymerizable with (M1), (M2) and (M3), and
M 1, M2, M3 and A 1 are contained in amounts of from 5 to 70 % by mole, from 5 to 70 % by mole, from 5 to 75 % by mole and from 0 to 50 % by mole, respectively.

Further it is preferable that the compound having fluorine atom is a fluorine-containing copolymer having a ring structure in its trunk chain and containing acid-labile functional groups which are converted to carboxyl due to action of an acid, and the fluorine-containing copolymer is represented by the formula (2):

-(M1)-(M4)-(A2)- (2)

wherein the structural unit M1 is a structural unit derived from an ethylenic monomer having 2 or 3 carbon atoms and at least one fluorine atom,
the structural unit M4 is a structural unit derived from a monomer of a cyclic aliphatic unsaturated hydrocarbon which is copolymerizable with M1, may be subjected to replacing with fluorine atom and has an acid-labile functional group Y²,
the structural unit A2 is a structural unit derived from monomer copolymerizable with (M1) and (M4), and
M1, M4 and A2 are contained in amounts of from 5 to 70 % by mole, from 5 to 60 % by mole and from 0 to 50 % by mole, respectively.

It is preferable that the acid-labile functional groups Y¹ and Y² in those fluorine-containing copolymers are -C(CH₃)₃.

It is preferable that the structural unit having an acid-labile functional group in the fluorine-containing copolymer is contained in an amount of not less than 15 % by mole based on the whole structural units constituting the fluorine-containing copolymer.

It is further preferable to use the fluorine-containing copolymer having the acid-labile functional groups which are partly dissociated and converted to carboxyl.

It is also preferable to use the fluorine-containing copolymer having the acid-labile functional groups which are partly dissociated and converted to carboxyl and containing the carboxyl in an amount of not less than 1 % by mole and less than 15 % by mole based on the whole structural units constituting the fluorine-containing copolymer.

In the method of forming a fine resist pattern of the present invention, it is preferable to use F₂ excimer laser beam as energy ray.

In the method of forming a fine resist pattern of the present invention, it is preferable to use ArF excimer laser beam as energy ray.

In the method of forming a fine resist pattern of the present invention, it is preferable to use KrF excimer laser beam as energy ray.

In the method of forming a fine resist pattern of the present invention, it is preferable to use high energy electron beam as energy ray.

In the method of forming a fine resist pattern of the present invention, it is preferable to use high energy ion laser beam as energy ray.

In the method of forming a fine resist pattern of the present invention, it is preferable to use X-ray as energy ray.

In the method of forming a fine resist pattern of the present invention, it is preferable to coat, on a substrate, the photo-sensitive composition prepared using propylene glycol monomethyl ether acetate as a solvent.

In the method of forming a fine resist pattern of the present invention, it is preferable to coat, on a substrate, the photo-sensitive composition prepared using ethyl lactate as a solvent.

The present invention relates to a method of forming a fine circuit pattern comprising a step for forming the fine resist pattern by any of the above-mentioned methods on a substrate or on a given layer on the substrate and a step for forming an intended circuit pattern by etching the substrate or the given layer through the fine resist pattern.

### BRIEF DESCRIPTION OF DRAWINGS

Fig. 1 is a cross-sectional view showing the steps for forming the fine pattern of the present invention.
Fig. 2 is a vacuum ultraviolet absorption spectrum of the fluorine-containing resin in the present invention.
Fig. 3 is a sensitivity curve showing a difference in performance by the acid generator of the photo-sensitive composition prepared from the fluorine-containing resin in the present invention.
Fig. 4 is a sensitivity curve showing a difference in characteristic by the solvent of the photo-sensitive composition prepared from the fluorine-containing resin in the present invention.
Fig. 5 is a sensitivity curve showing an effect of adding a basic substance to the photo-sensitive composition prepared from the fluorine-containing resin in the present invention.
Fig. 6 is a sensitivity curve showing a difference in performance of the photo-sensitive composition due to a difference in a protection ratio of the fluorine-containing resin in the present invention.
Fig. 7 is a photograph of a scanning type electron microscope showing a resist pattern formed using a photo-sensitive composition prepared using the fluorine-containing resin in the present invention.
Fig. 8 is a photograph of a scanning type electron microscope showing a cross-section of a resist pattern which shows an effect of treating the substrate with an adhesion improver in the photo-sensitive composition prepared from the fluorine-containing resin in the present invention.
Fig. 9 is a photograph of a scanning type electron microscope showing a cross-section of a resist pattern which shows an effect of providing an antireflection film on a substrate in the photo-sensitive composition prepared from the fluorine-containing resin in the present invention.

### BEST MODE FOR CARRYING OUT THE INVENTION

Next, the present invention is explained below in detail.

As the chemically amplifying resist directed by the present invention, there are positive type resist and negative type resist.

Examples of the positive type resist are, for instance, a three-component composition comprising an alkali-soluble resin, dissolution inhibitor and acid generator and a two-component composition comprising an alkali-soluble resin to which a group (dissolution-inhibiting group) having a dissolution-inhibiting effect is introduced and an acid generator. In such a positive type chemically amplifying resist, when the resist is in un-exposed state, solubility thereof in an alkali developing solution is inhibited by a dissolution inhibitor (or dissolution-inhibiting group).

The photo-sensitive composition in the present invention basically contains a selected material having high transparency against exposure light having a short wavelength such as F₂ excimer laser beam in order to form a precise fine pattern.

First, a high molecular weight material having high transparency in the present invention is explained below.

The photo-sensitive composition (photo-sensitive resin) used for the method of forming a fine pattern of the present invention is characterized by the use of the compound containing fluorine atom in its molecular structure.

In other words, the materials used for the method of forming a fine pattern of the present invention are fluorine-containing copolymers having a ring structure in a trunk chain thereof and containing acid-labile functional groups which are converted to carboxyl due to action of an acid, and the firstly preferred fluorine-containing copolymer is the fluorine-containing polymer represented by the following formula (1).

-(M1)-(M2)-(M3)-(A1)- (1)

wherein the structural unit M 1 is a structural unit derived from an ethylenic monomer having 2 or 3 carbon atoms and at least one fluorine atom,
the structural unit M2 is a structural unit derived from a cyclic aliphatic unsaturated hydrocarbon which is copolymerizable with M and may be subjected to replacing with fluorine atom,
the structural unit M3 is represented by: 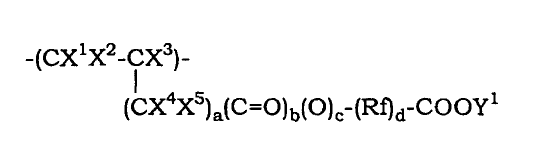 wherein Y¹ is an acid-labile functional group; X¹ and X² are the same or different and each is H or F; X³ is H, F, Cl, CH₃ or CF₃; X⁴ and X⁵ are the same or different and each is H, F or CF₃; Rf is a fluorine-containing alkylene group having 1 to 40 carbon atoms or a fluorine-containing alkylene group having 2 to 100 carbon atoms and ether bond; a is 0 or an integer of from 1 to 3; b, c and d are the same or different and each is 0 or 1,
the structural unit A1 is a structural unit derived from monomer copolymerizable with (M1), (M2) and (M3), and
M1, M2, M3 and A1 are contained in amounts of from 5 to 70 % by mole, from 5 to 70 % by mole, from 5 to 75 % by mole and from 0 to 50 % by mole, respectively.

This fluorine-containing copolymer contains, as an essential component, the structural unit of an ethylenic monomer having acid-labile functional groups which is represented by M3. The acid-labile functional groups in M3 are converted to carboxyl due to action of an acid and solubility in an aqueous alkali solution (developing solution) is imparted to the polymer.

This is preferable because by selecting the structure M3, copolymerizability becomes good, the acid-labile functional groups can be introduced to the polymer in a high concentration and good solubility in an aqueous alkali solution (developing solution) can be obtained after the dissociation by an acid. Also it is possible to introduce -Rf- to a side chain of M3, which is preferred because transparency of the polymer can be enhanced.

The secondly preferred fluorine-containing copolymer is one represented by the formula (2):

-(M1)-(M4)-(A2)- (2)

wherein the structural unit M1 is a structural unit derived from an ethylenic monomer having 2 or 3 carbon atoms and at least one fluorine atom,
the structural unit M4 is a structural unit derived from a monomer of a cyclic aliphatic unsaturated hydrocarbon which is copolymerizable with M1, may be subjected to replacing with fluorine atom and has an acid-labile functional group Y²,
the structural unit A2 is a structural unit derived from monomer copolymerizable with (M1) and (M4), and
M1, M4 and A2 are contained in amounts of from 5 to 70 % by mole, from 5 to 60 % by mole and from 0 to 50 % by mole, respectively.

This fluorine-containing copolymer contains, as an essential component, the structural unit M4 of the monomer which is a cyclic aliphatic unsaturated hydrocarbon having acid-labile functional groups. The acid-labile functional groups in M4 are converted to carboxyl due to action of an acid and solubility in an aqueous alkali solution (developing solution) is imparted to the polymer. This is preferable because a glass transition point can be increased, and further transparency and dry etching resistivity can be enhanced.

In the fluorine-containing copolymers of the formulae (1) and (2), the structural unit M1 comprises a fluorine-containing ethylenic monomer and is preferred because an effect of enhancing transparency, particularly transparency against ultraviolet light having a short wavelength (for example, 157 nm) can be imparted to the copolymer.

Examples of the monomer constituting the structural unit M1 are CF₂=CF₂, CF₂=CFCl, CH₂=CF₂, CFH=CH₂, CFH=CF₂, CF₂=CFCF₃, CH₂=CFCF₃, CH₂=CHCF₃ and the like.

Particularly preferred are CF₂=CF₂ and CF₂=CFCI from the viewpoint of good copolymerizability and a high effect of imparting transparency.

In the fluorine-containing copolymer of the formula (1), the structural unit M2 comprises a cyclic aliphatic unsaturated hydrocarbon which is selected from those copolymerizable with the fluorine-containing ethylenic monomer constituting the above-mentioned M1. The introduction of M2 is preferred because dry etching resistivity in addition to transparency can be enhanced.

Also a part or the whole of hydrogens of the structural unit M2 may be replaced with fluorine atoms, which is preferred because further transparency can be imparted to the polymer.

Examples of the monomer constituting the structural unit M2 are concretely: 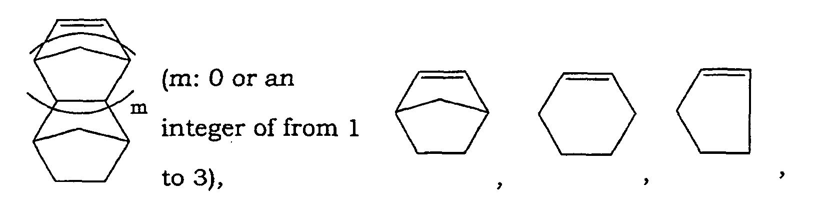 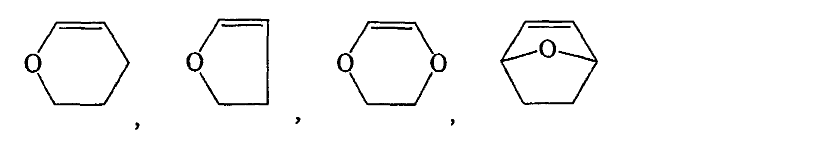 and fluorine-containing alicyclic monomers represented by the formula: 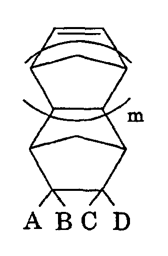 wherein A, B, C and D are H, F, an alkyl group having 1 to 10 carbon atoms or a fluorine-containing alkyl group having 1 to 10 carbon atoms;
m is 0 or an integer of from 1 to 3, any one of A to D has fluorine atom. Examples thereof are: 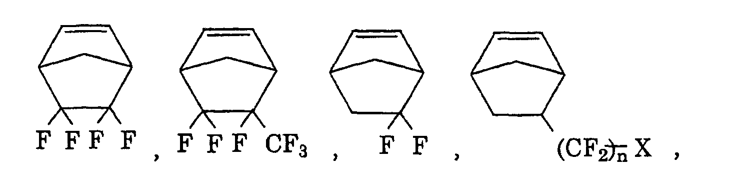 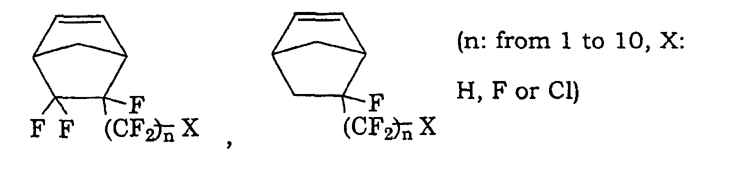 and the like.

In addition, there are: 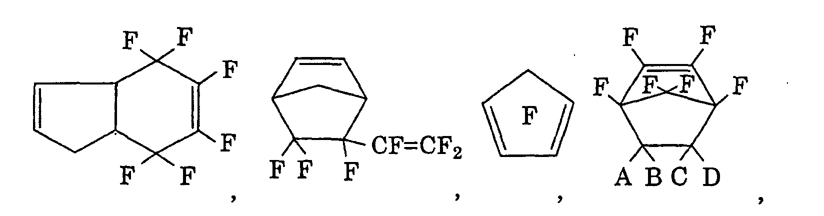 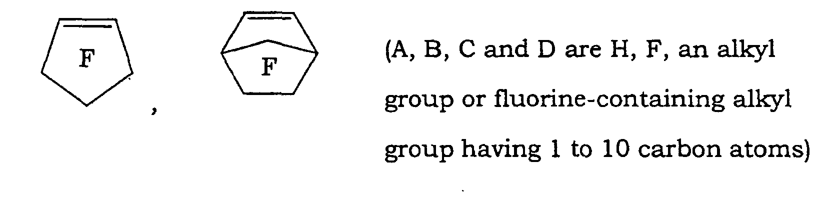 and the like.

In the fluorine-containing copolymer of the formula (1), the structural unit M3 comprises an ethylenic monomer having an acid-labile functional group which is converted to carboxyl due to action of an acid, and may contain or may not contain fluorine atom.

Examples of the structural unit M3 not containing fluorine atom (d=0) are concretely:
Acrylic monomers such as:
   CH₂=CHCOOY¹, CH₂=C(CH₃)COOY¹ and CH₂=CClCOOY¹
Maleic acid monomers such as: 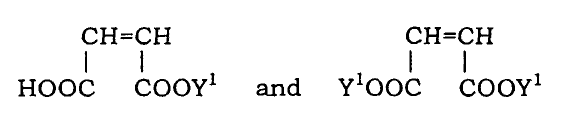
Allyl monomers such as:
   CH₂=CHCH₂COOY¹ and CH₂=CHCH₂OCH₂CH₂COOY¹,
Styrene monomers such as:

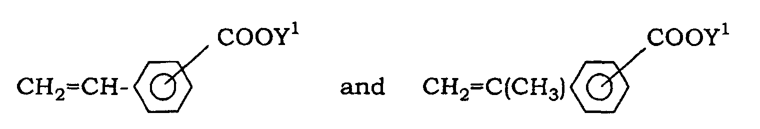

Also examples of the structural unit M3 containing fluorine atom in its trunk chain (d=0) are:
Fluorine-containing acrylic monomers such as:
   CH₂=CFCOOY¹, CH₂=C(CF₃)COOY¹ and CF₂=CFCOOY¹
Fluorine-containing allyl monomers such as:
   CH₂=CFCF₂COOY¹ CF₂=CFCF₂COOY¹ and CH₂=CHCF₂COOY¹
Fluorine-containing styrene monomers such as:

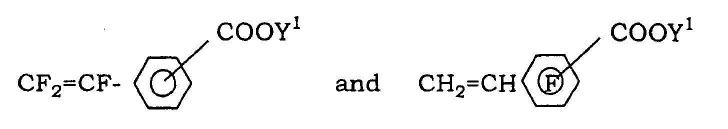

Examples of M3 having a fluoroalkyl group in its side chain (d=1) are preferably M3-1 represented by:

CH₂=CFCF₂O-Rf COOY¹

wherein Rf and Y¹ are as defined in M3,
and concretely there are: 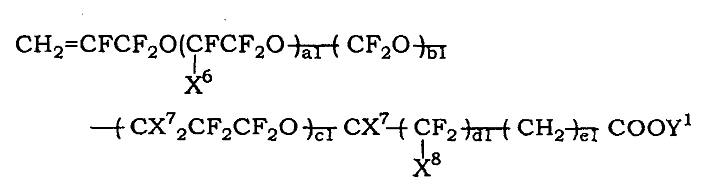 wherein a1 + b1 + c1 is from 0 to 30, d1 is 0 or 1, e1 is from 0 to 5, X⁶ is F or CF₃, X⁷ is H or F, X⁸ is H, F or CF₃,
and further concretely there are: 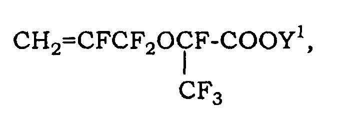 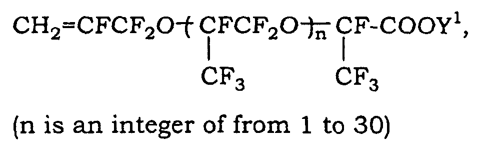 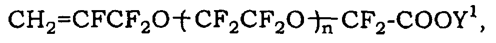 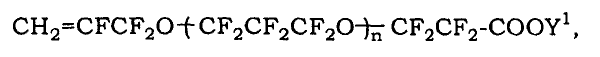 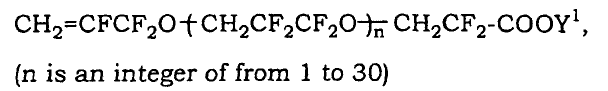 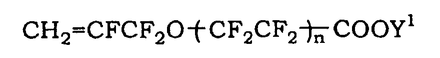 and the like.

Also preferred are M3-2 represented by:

CF₂=CFO-Rf-COOY¹

wherein Rf and Y¹ are as defined in M3,
and concretely there are: 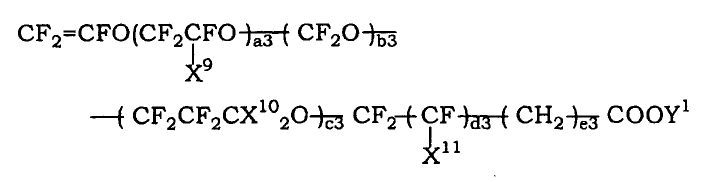 wherein a3 + b3 + c3 is from 0 to 30, d3 is 0, 1 or 2, e3 is from 0 to 5, X⁹ and X¹¹ are F or CF₃, X¹⁰ is H or F,
and further concretely there are:

CF₂=CFOCF₂CF₂-COOY¹,

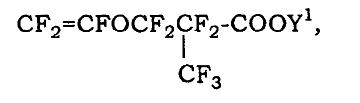

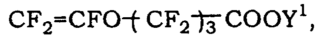

CF₂=CFOCF₂CF₂OCF₂COOY¹,

CF₂=CFOCF₂CF₂CH₂OCF₂CF₂-COOY¹

and the like.

Other examples of the monomer constituting (M3) are:

CF₂=CFCF₂-O-Rf-COOY¹,

CF₂=CF-Rf-COOY¹,

CH₂=CH-Rf-COOY¹, CH₂=CHO-Rf-COOY¹

(Rf is the same as Rf² of the formula (2))
and the like. Further concretely there are:

CF₂=CF-CF₂OCF₂CF₂CF₂COOY¹,

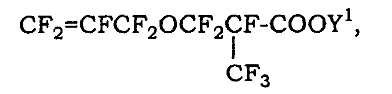

CF₂=CFCF₂-COOY¹, CH₂=CHCF₂CF₂-COOY¹,

CH₂=CHCF₂CF₂CH₂COOY¹,

CH₂=CHCF₂CF₂CF₂CF₂-COOY¹,

CH₂=CHCF₂CF₂CF₂CF₂CH₂COOY¹,

CH₂=CH₂O-CH₂CF₂CF₂-COOY¹,

CH₂=CH₂OCH₂CF₂CF₂CH₂COOY¹

and the like.

In the fluorine-containing copolymer of the formula (2), the structural unit M4 comprises a cyclic aliphatic unsaturated hydrocarbon copolymerizable with the fluorine-containing ethylenic monomer constituting M 1 and has an acid-labile functional group which can be converted to carboxyl by an acid. The introduction of M4 is preferred because the polymer can be provided with a function of being soluble in an aqueous alkali solution (developing solution), transparency and dry etching resistivity and also because dry etching resistivity of the whole polymer can be further enhanced.

Examples of the monomer constituting the structural unit M4 are concretely alicyclic monomers represented by:

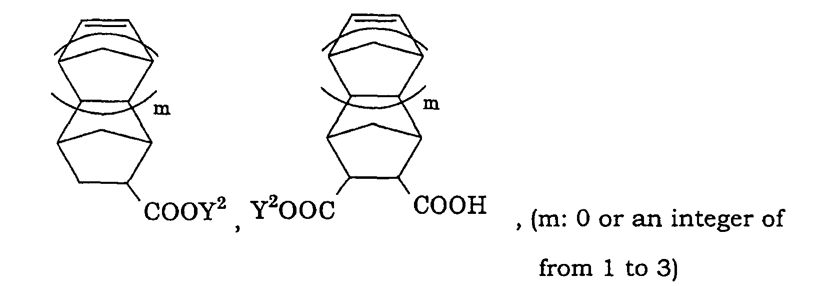

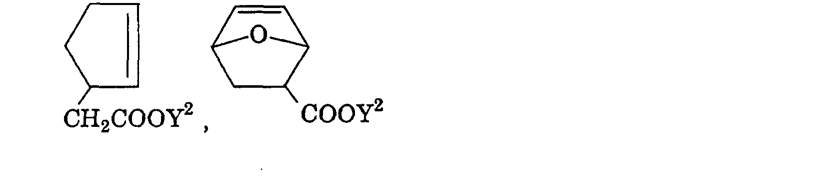

Further a part or the whole of hydrogen atoms of the structural unit M4 may be replaced with fluorine atoms, which is preferable because higher transparency can be imparted to the polymer.

Concretely there are fluorine-containing monomers represented by: 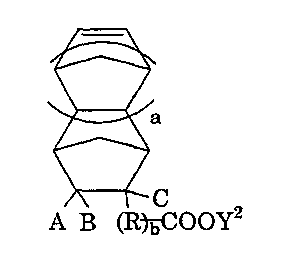 wherein A, B and C are H, F, an alkyl group having 1 to 10 carbon atoms or a fluorine-containing alkyl group having 1 to 10 carbon atoms; R is a divalent hydrocarbon group having 1 to 20 carbon atoms, a fluorine-containing alkylene group having 1 to 20 carbon atoms or a fluorine-containing alkylene group having 2 to 100 carbon atoms and ether bond; a is 0 or an integer of from 1 to 3; b is 0 or 1; Y² is an acid-labile functional group; when b is 0 or R does not have fluorine atom, any one of A to C is fluorine atom or a fluorine-containing alkyl group.

It is preferable that any one of A, B and C is fluorine atom, and when fluorine atom is not contained in A to C, a fluorine content of R is not less than 60 % and it is further preferable that R is a perfluoroalkyl group because transparency can be imparted to the polymer.

Examples thereof are: 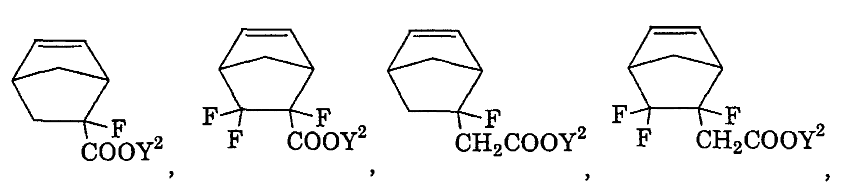 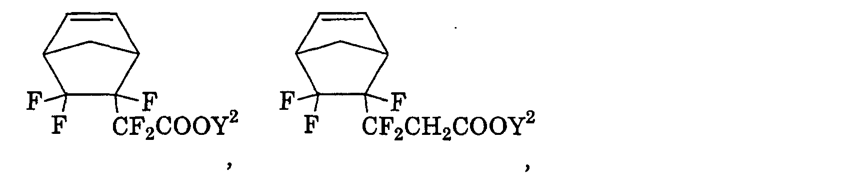 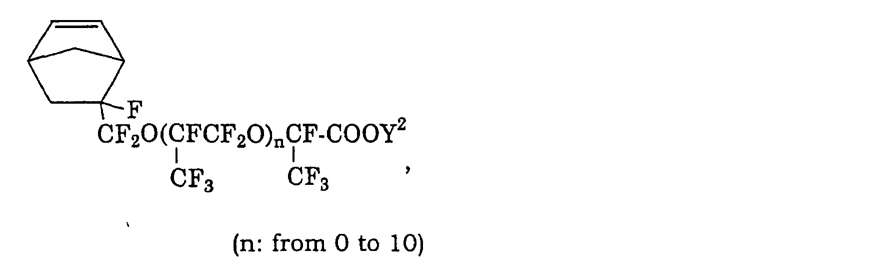 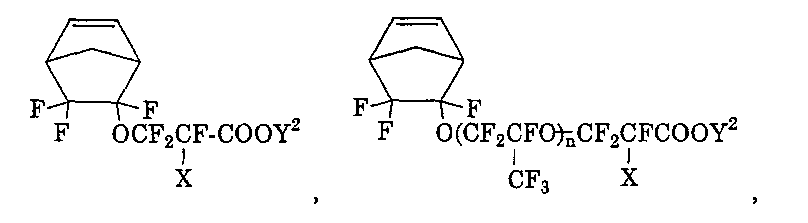 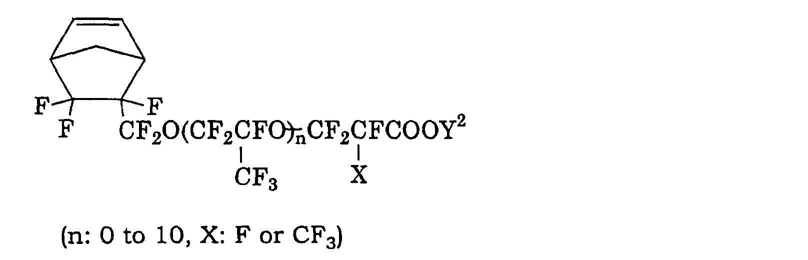 and the like.

Also there are fluorine-containing monomers represented by: 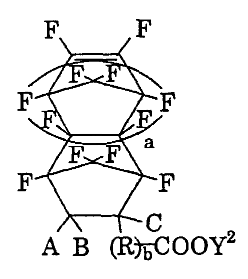 wherein A, B and C are H, F, an alkyl group having 1 to 10 carbon atoms or a fluorine-containing alkyl group having 1 to 10 carbon atoms; R is a divalent hydrocarbon group having 1 to 20 carbon atoms, a fluorine-containing alkylene group having 1 to 20 carbon atoms or a fluorine-containing alkylene group having 2 to 100 carbon atoms and ether bond; a is 0 or an integer of from 1 to 3; b is 0 or 1; Y² is an acid-labile functional group.

Concretely there are those having norbornene backbone such as: 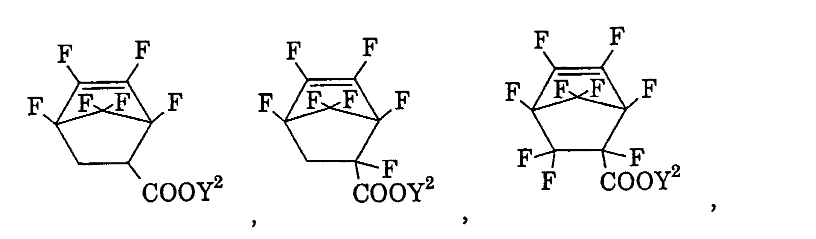 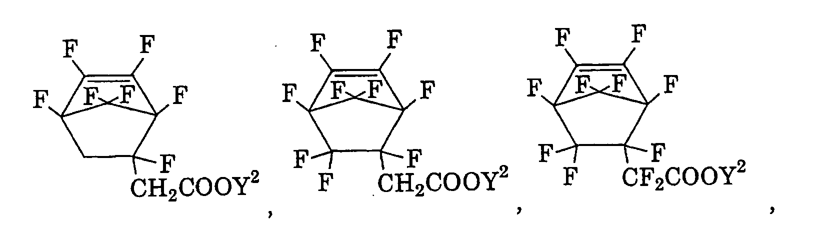 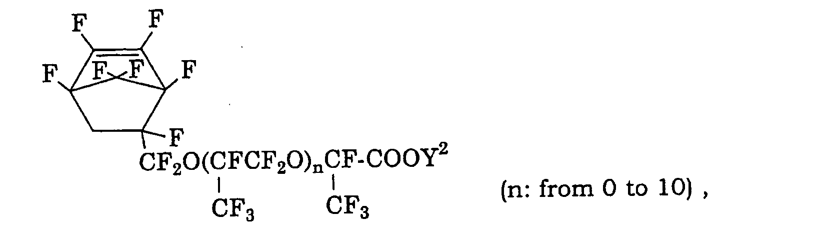 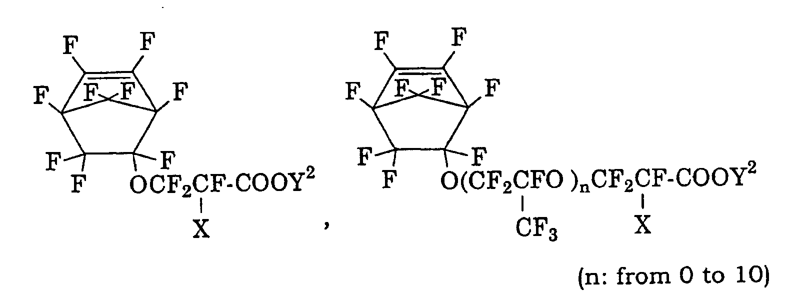 and

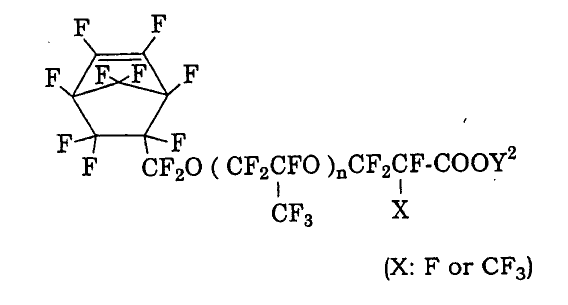

Other examples thereof are:

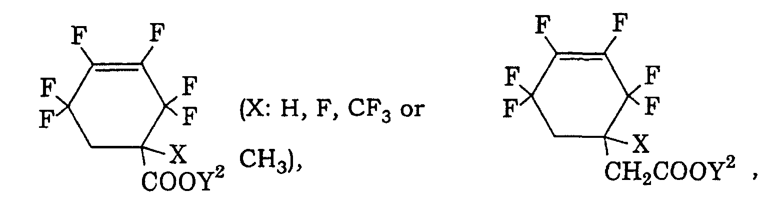

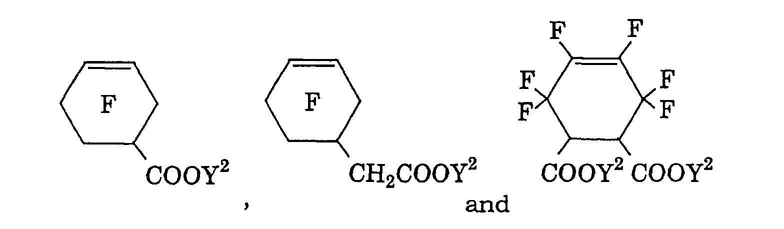

In the polymers of the formulae (1) and (2), the structural units A1 and A2 are optional components and are selected from those copolymerizable with the monomers constituting the other structural units.

Examples thereof are, for instance:
Acrylic monomer (excluding monomers giving M1 and M2): 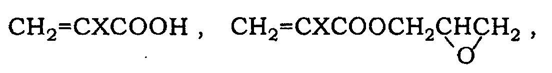 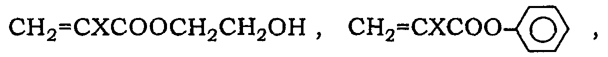 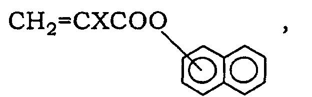 and 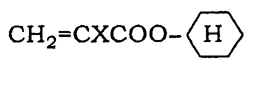 wherein X is selected from H, CH₃, F and CF₃.
Styrene monomer: 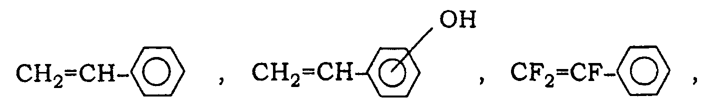 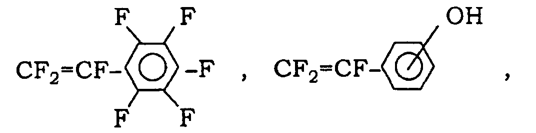 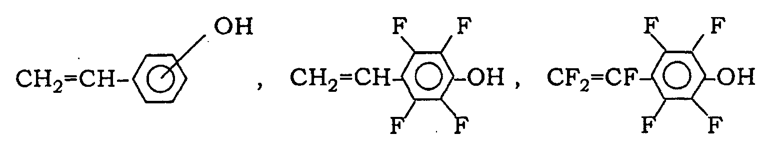 and 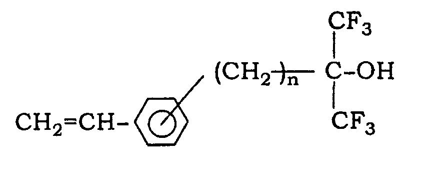 wherein n is 0 or an integer of 1 or 2.
Ethylene monomer:
   CH₂=CH , CH₂=CHCH₃ , CH₂=CHCl and the like.
Maleic acid monomer: 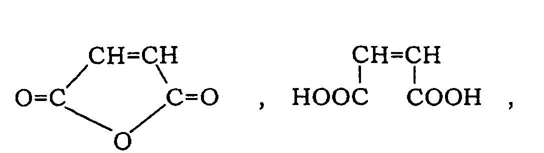 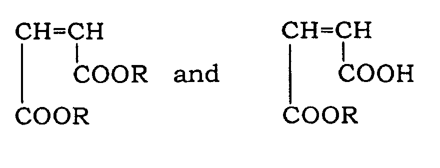 wherein R is a hydrocarbon group having 1 to 20 carbon atoms.
Allyl monomer:
   CH₂=CHCH₂Cl , CH₂=CHCH₂OH, CH₂=CHCH₂COOH , CH₂=CHCH₂Br and the like.
Allyl ether monomer:
   CH₂=CHCH₂OR (R is a hydrocarbon group having 1 to 20 carbon atoms), 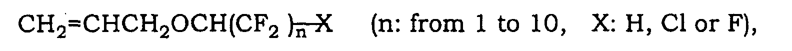 CH₂=CHCH₂OCH₂CH₂COOH, 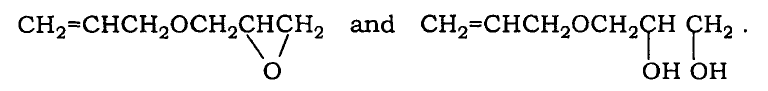
Other monomers such as: 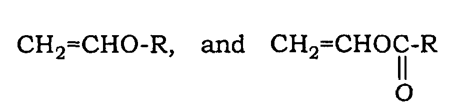 (R is an alkyl group which has 1 to 20 carbon atoms and may be replaced with fluorine atom),
and concretely there are: 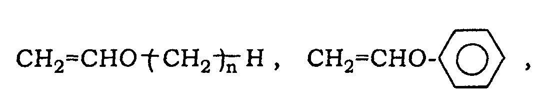 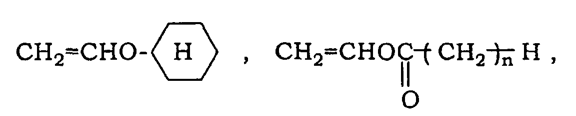 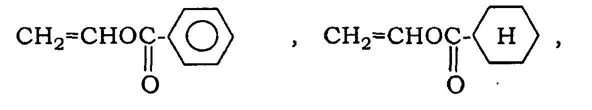 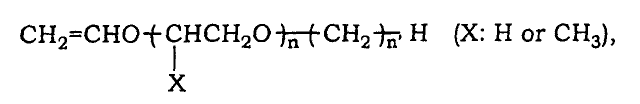
and the like.

In the above-mentioned fluorine-containing copolymers of the formulae (1) and (2) of the present invention, the acid-labile functional groups Y¹ and Y² are selected from hydrocarbons having tertiary carbons in which the tertiary carbons are directly bonded to carboxyl. For example, there are a t-butyl group, 1,1-dimethylpropyl group, adamantyl group, ethyl adamantyl group and the like. Preferred are a t-butyl group and -C(CH₃)₃ from the viewpoint of particularly good reactivity in acid dissociation reaction.

In the fluorine-containing copolymers of the formulae (1) and (2) of the present invention, it is necessary that the fluorine-containing copolymer having carboxyl which is obtained after the dissociation reaction by an acid has sufficient solubility in a developing solution. A content of the acid-labile functional group necessary therefor varies depending on the components (kind of monomers) and molecular weight of the polymer, etc. The content is preferably not less than 15 % by mole, further preferably not less than 20 % by mole, more preferably not less than 25 % by mole based on the whole monomers constituting the fluorine-containing copolymer.

In the studies of a resist composition obtained from a fluorine-containing polymer having an acid-labile functional group and the studies of a resist pattern formation by using the resist composition, the present inventors have found problems with poor adhesion of the fluorine-containing polymer to a silicon wafer substrate and occurrence of peeling of a resist at developing and cracking of a fine resist pattern.

Further there was found a problem that due to a high water repellency of a surface of a resist film, a developing solution was repelled at puddle-developing and did not extend over the resist film and thus uniform developing could not be obtained.

The present inventors have made intensive studies to solve those problems and have found that the above-mentioned two problems could be solved by dissociating a part of the acid-labile functional groups in the fluorine-containing copolymer of the present invention to carboxyl. Namely, it was found that when even a part of the fluorine-containing copolymer is dissociated (or partly deprotected), adhesion to the substrate is improved and repelling of the developing solution is improved, which makes it possible to obtain uniform developing.

In the fluorine-containing copolymer which is used in the present invention, a proportion of carboxyl obtained by dissociating (deprotecting) the acid-labile functional group varies depending on kind and components of the copolymer, etc. The proportion of carboxyl after the dissociation is preferably not less than 0.5 % by mole and less than 15 % by mole based on the whole structural units constituting the fluorine-containing copolymer. The proportion is more preferably from 1 to 10 % by mole, further preferably from 2 to 5 % by mole. If a dissociation ratio (deprotection ratio) becomes too high and the carboxyl content becomes too high, un-exposed portions also become soluble at developing and a resist pattern cannot be formed.

If the dissociation ratio (deprotection ratio) becomes too low and the carboxyl content becomes too low, an effect of exhibiting adhesion to a substrate and uniformity of developing becomes insufficient.

Next, the acid generator for the photo-sensitive composition of the present invention is explained below.

In the photo-sensitive composition of the present invention, as the compound (acid generator) generating an acid by irradiation of energy rays, there can be used optional compound or mixture which generates an acid by irradiation of, for example, light having a short wavelength such as F2 excimer laser beam, high energy electron beam, ion beam, X-ray or the like.

Examples of the compound (acid generator) generating an acid by irradiation of energy rays are, for instance, salts such as diazonium salt, phosphonium salt, sulfonium salt, iodonium salt, CF₃SO₃, p-CH₃PhSO₃ and p-NO₂PhSO₃ (Ph represents phenyl), organic halides, orthoquinone-diadidosulfonyl chloride, sulfonic acid ester and the like.

The above-mentioned organic halides are compounds forming hydrohalogenic acids. Examples thereof are those disclosed in USP3,515,551, USP3,536,489, USP3,779,778, DE Patent Publication No.2,243,621, etc.

Examples of the other compounds generating an acid by irradiation of light are those disclosed in JP54-74728A, JP55-24113A, JP55-77742A, JP60-3626A, JP60-138539A, JP56-17345A and JP56-36209A.

Examples of those compounds are di(p-tertiarybutylphenyl)iodonium trifluoromethane sulfonate, diphenyliodonium trifluoromethane sulfonate, benzoine tosilate, orthonitrobenzylparatoluene sulfonate, triphenylsulfonium trifluoromethane sulfonate, tri(tertiary-butyl phenyl)sulfonium trifluoromethane sulfonate, benzenediazonium paratoluene sulfonate, 4-(di-n-propylamino)-benzonium tetrafluoroborate, 4-p-tolyl-mercapto-2,5-diethoxy-benzenediazonium hexafluorophosphate, tetrafluoroborate, diphenylamine-4-diazonium sulfate, 4-methyl-6-trichloromethyl-2-pyrone, 4-(3,4,5-trimethoxy-styryl)-6-trichloromethyl-2-pyrone, 4-(4-methoxy-styryl)-6-(3,3,3-trichloro-propenyl)-2-pyrone, 2-trichloromethyl-benzoimidazole, 2-tribromomethyl-quinoline, 2,4-dimethyl- 1-tribromoacetyl-benzene, 4-dibromoacetyl-benzoate, 1,4-bis-dibromomethyl-benzene, tris-dibromomethyl-s-triadine, 2-(6-methoxynaphthyl-2-yl)-4,6-bis-trichloromethyl-s-triadine, 2-(naphthyl-1-yl)-4,6-bis-trichloromethyl-s-triadine, 2-(naphthyl-2-yl)-4,6-bis-trichloromethyl-s-triadine, 2-{4-ethoxyethyl-naphthyl-1-yl)-4,6-bis-trichloromethyl-s-triadine, 2-(benzopyrani-3-yl)-4,6-bis-trichloromethyl-s-triadine, 2-(4-methoxy-anthrasi-1-yl)-4,6-bis-trichloromethyl-s-triadine, 2-(phenanthy-9-yl)-4,6-bis-trichloromethyl-s-triadine, o-naphthoquinonediazide-4-sulfonic acid chloride and the like. Examples of sulfonic acid ester are naphthoquinonediazide-4-sulfonic acid ester, naphthoquinonediazide-5-sulfonic acid ester, p-toluenesulfonate-2,6-dinitrobenzylester and the like.

As the above-mentioned compound (acid-generator) generating an acid by irradiation of chemical radiation, it is particularly preferable to use o-quinonediazide compound. The o-quinonediazide compound is not limited particularly and an ester of o-quinonediazide sulfonic acid and phenol compound is preferred. The ester of o-quinonediazide sulfonic acid and phenol compound can be prepared through known method by reacting o-quinonediazide sulfonic acid chloride with a phenol compound.

Examples of the o-quinonediazide sulfonic acid chloride which can be used are, for instance, 1-benzophenone-2-diazo-4-sulfonic acid chloride, 1-naphthoquinone-2-diazo-5-sulfonic acid chloride, 1-naphthoquinone-2-diazo-4-fulfonic acid chloride and the like.

Examples of the phenol compound which can be used are, for instance, phenol, cresol, xylenol, bisphenol A, bisphenol S, hydroxybenzophenone, 3, 3, 3', 3'-tetramethyi-1,1'-spirobiinda5,6,7,5',6',7'-hexanol, phenolphthalein, dimethyl p-hydroxybenzylidene malonate, dinitrile p-hydroxybenzylidene malonate, cyanophenol, nitrophenol, nitrosophenol, hydroxyacetophenone, methyl trihydroxybenzoate, polyvinylphenol, novolak resin and the like. Examples of such a o-quinonediazide compound are those represented by the following formulae (3) to (7).

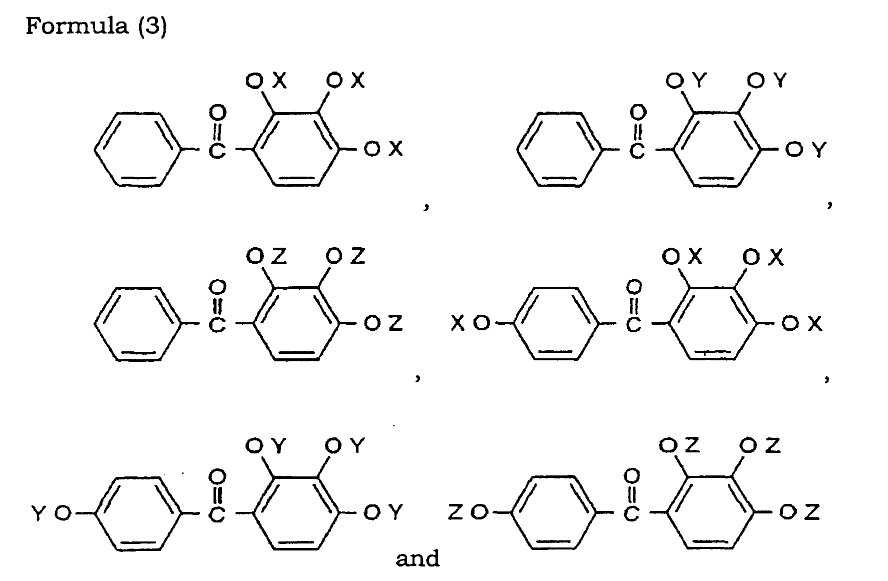

In the above-mentioned formulae,
X represents: 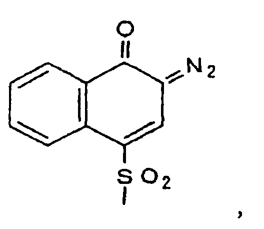 Y represents: 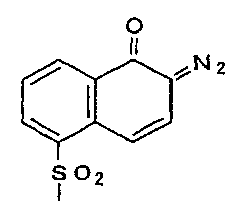 and
Z represents:

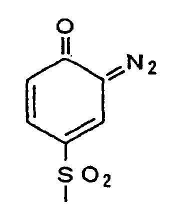

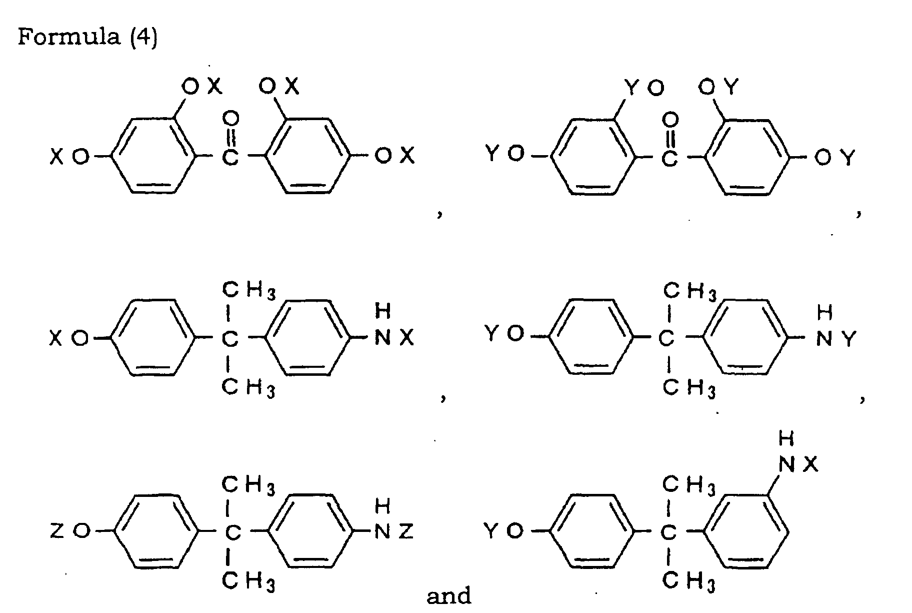

In the above-mentioned formulae,
X represents: 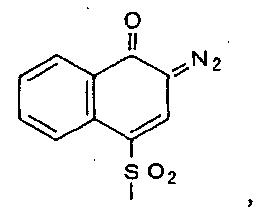 Y represents: 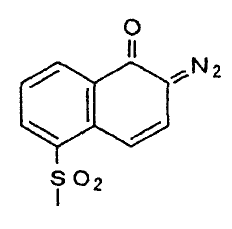 and
Z represents:

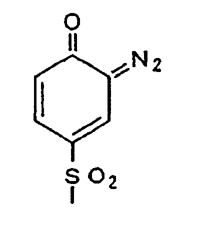

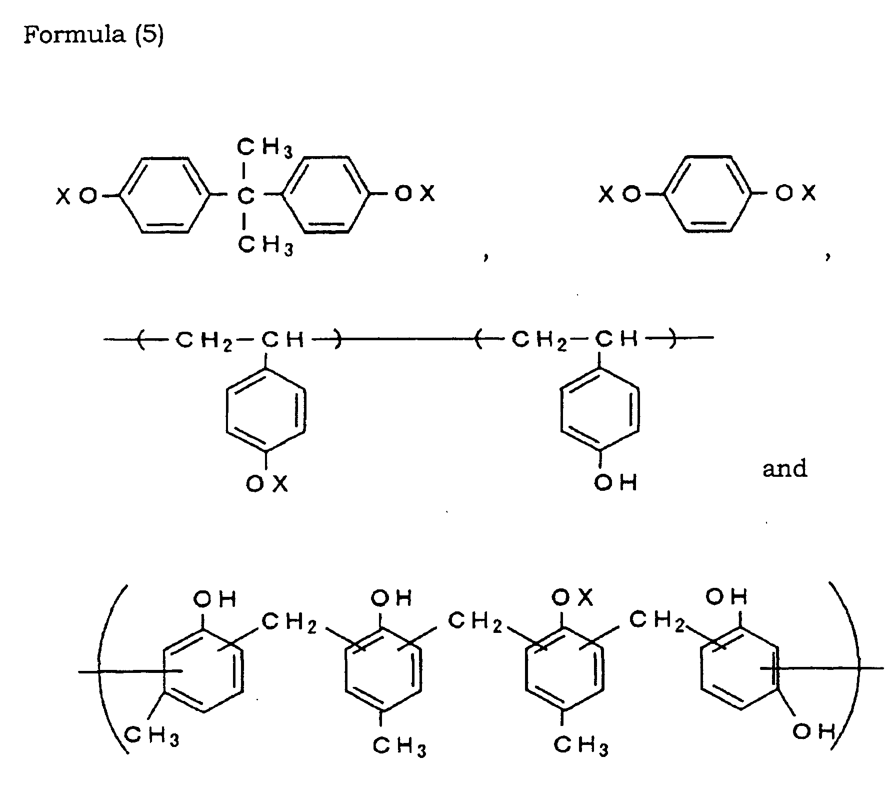

In the above-mentioned formulae,
X represents:

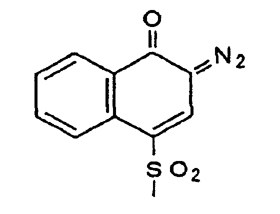

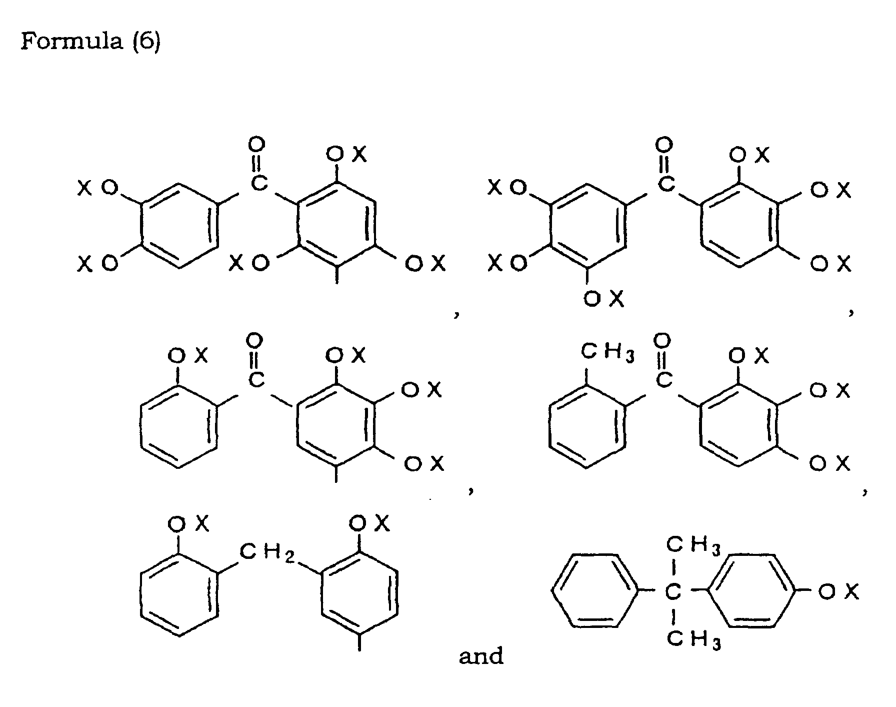

In the above-mentioned formulae,
X represents:

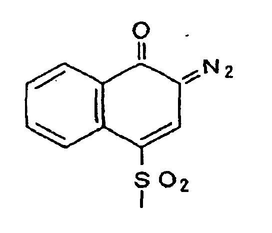

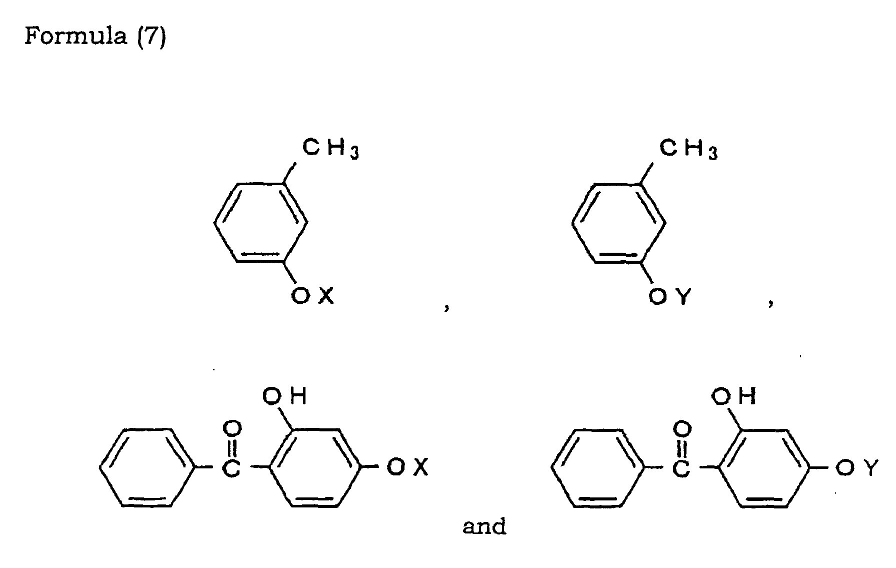

In the above-mentioned formulae,
X represents: 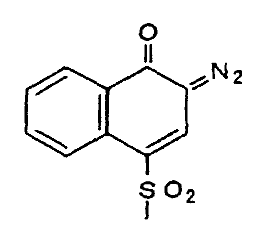 and
Y represents:

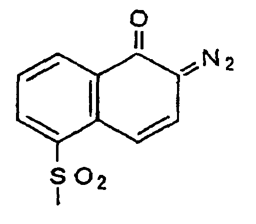

Among the above-mentioned o-quinonediazide compounds, particularly 1-naphthoquinone-2-diazo-4-sulfonic acid ester is suitable. It is known that such an ester generates, by irradiation of light, carboxylic acid and sulfonic acid which is stronger than carboxylic acid as disclosed in J. J. Grimwaid, C. Gal, S. Eidelman, SPIE Vol. 1262, Advances in Resist Technology and Processing VII, p444 (1990), and the ester is particularly effective because of its large catalytic action.

As the above-mentioned compound (acid-generator) which generates an acid by irradiation of the chemical radiation, there can be suitably used the compounds (A-1), (A-2) and (A-3) represented by the following formulae (8), (9) and (10), respectively.

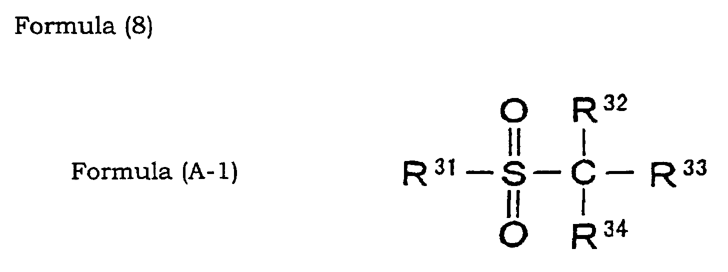

In the above formula (A-1 ), R³¹ represents a monovalent organic group or a monovalent organic group to which at least one selected from the group consisting of halogen atom, nitro group and cyano group is introduced, R³², R³³ and R³⁴ independently represent hydrogen atom, halogen atom, nitro group, cyano group, a monovalent organic group or a monovalent organic group to which at least one selected from the group consisting of halogen atom, nitro group and cyano group is introduced.

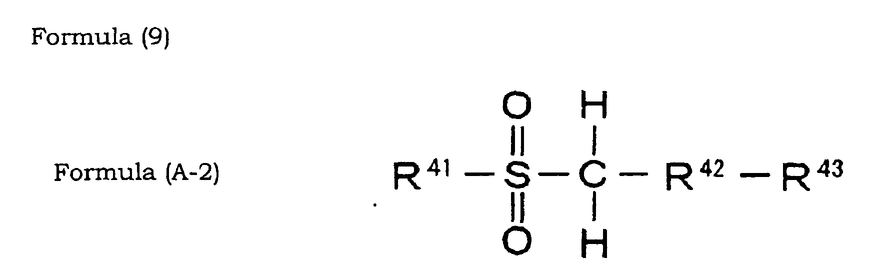

In the formula (A-2), R⁴¹ and R⁴³ independently represent a monovalent organic group or a monovalent organic group to which at least one selected from the group consisting of halogen atom, nitro group and cyano group is introduced, R⁴² represents a sulfonyl group or carbonyl group.

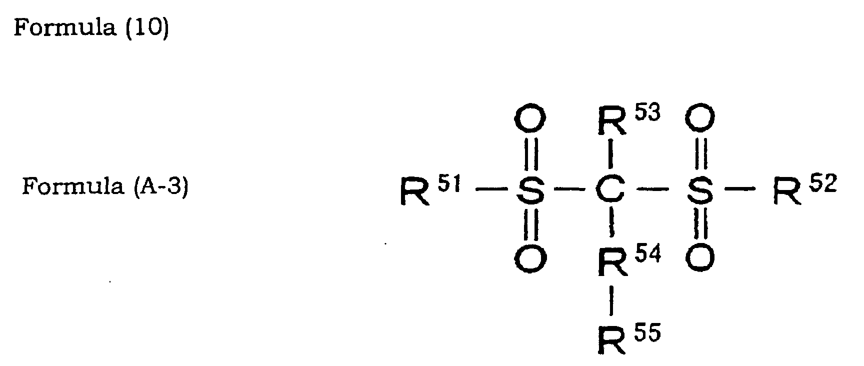

In the above formula (A-3), R⁵¹, R⁵² and R⁵⁵ independently represent a monovalent organic group or a monovalent organic group to which at least one selected from the group consisting of halogen atom, nitro group and cyano group is introduced, R⁵³ represents hydrogen atom, a monovalent organic group or a monovalent organic group to which at least one selected from the group consisting of halogen atom, nitro group and cyano group is introduced, R⁵⁴ represents a sulfonyl group, sulfynyl group, sulfur atom or carbonyl group.

Examples of the monovalent organic group which is introduced to the compound of the formula (A-1) as R³¹, R³², R³³ and R³⁴ are allyl, anisyl, anthraquinonyl, acetonaphthyl, anthryl, azulenyl, benzofuranyl, benzoquinonyl, benzoxadinyl, benzoxazoryl, benzyl, biphenylenyl, bornyl, butenyl, butyl, cinnamyl, cresotoyl, cumenyl, cyclobutanedienyl, cyclobutenyl, cyclobutyl, cyclopentadienyl, cyclopentatolyenyl, cycloheptyl, cyclohexenyl, cyclopentyl, cyclopropyl, cyclopropenyl, desyl, dimethoxyphenetyl, diphenylmethyl, docosyl, dodecyl, eicosyl, ethyl, fluorenyl, furfuryl, geranyl, heptyl, hexadecyl, hexyl, hydroxymethyl, indanyl, isobutyl, isopropyl, isopropylbenzyl, isoxazolyl, menthyl, mesityl, methoxybenzyl, methoxyphenyl, methyl, methylbenzyl, naphthyl, naphthylmethyl, nonyl, norbornyl, octacosyl, octyl, oxazinyl, oxazolidinyl, oxazolinyl, oxazolyl, pentyl, phenacyl, phenanthryl, phenetyl, phenyl, phthalidyl, propynyl, propyl, pyranyl, pyridyl, quinazolinyl, quinolyl, salicyl, terephthalyl, tetrazolyl, thiazolyl, thiaphthenyl, thienyl, tolyl, trityl, trimethylsilylmethyl, trimethylsilyloxymethyl, undecyl, valeryl, veratryl, xylyl and the like.

Examples of the monovalent organic group to which at least one selected from the group consisting of halogen atom, nitro group and cyano group is introduced are the above-mentioned groups in which hydrogen atom is replaced.

Examples of the compound of the above-mentioned formula (A-1) are phenyl methyl sulfone, ethyl phenyl sulfone, phenyl propyl sulfone, methyl benzyl sulfone, benzyl sulfone (dibenzyl sulfone), methyl sulfone, ethyl sulfone, butyl sulfone, methyl ethyl sulfone, methyl sulfonyl acetonitrile, phenylsulfonyl acetonitrile, toluenesulfonyl acetonitrile, benzyl phenyl sulfone, nitrophenyl sulfonyl acetonitrile, fluorophenyl sulfonyl acetonitrile, chlorophenyl sulfonyl acetonitrile, methoxyphenyl sulfonyl acetonitrile, α-methylphenyl sulfonyl acetonitrile, ethylsulfonyl acetonitrile, methylthiomethyl-p-toluyl sulfone, phenylsulfonyl acetophenone, phenylsulfonyl propionitrile, phenylsulfonyl propionate and ester compounds thereof, bromomethyl-2-(phenylsulfonylmethyl)benzene, naphthylmethylsulfone, 1-methyl-2-((phenylsulfonyl)methyl)benzene, trimethyl-3-(phenylsulfonyl)orthopropionate and the like.

In the present invention, among the compounds of the above-mentioned formula (A-1), preferred are those in which at least one of R³², R³³ and R³⁴ is an electron attractive group. Particularly preferred is one having cyano group from the viewpoint of a high efficiency of acid generation at exposing and enhancement of sensitivity of a photo-sensitive composition (resist).

Also the compound in which at least one of R³², R³³ and R³⁴ is hydrogen atom is preferred because solubility in alkali is high and generation of a scum is reduced when a developing treatment is carried out using an alkali solution for developing a resist.

In the compounds of the above-mentioned formula (A-1), a ring may be formed by bonding of R³¹ to R³², R³³ or R³⁴ or bonding of R³², R³³ and R³⁴ to each other. In that case, examples of the formed cyclic compound are thiopyrandioxide compounds such as phenylsulfonyl tetrahydropyran, phenylsulfonyl cyclohexane, 3-phenyl-2H-thiopyran-1,1-dioxide and 6-methyl-3-phenyl-2H-thiopyran-1,1-dioxide, biscyclictrisulfone compounds such as trimethylene sulfone, tetramethylene sulfone and 4-methyl-2,6,7-trithiabicyclo[2,2,2]-octane-2,2,6,6,7,7-hexaoxide, compounds represented by the following formula (11).

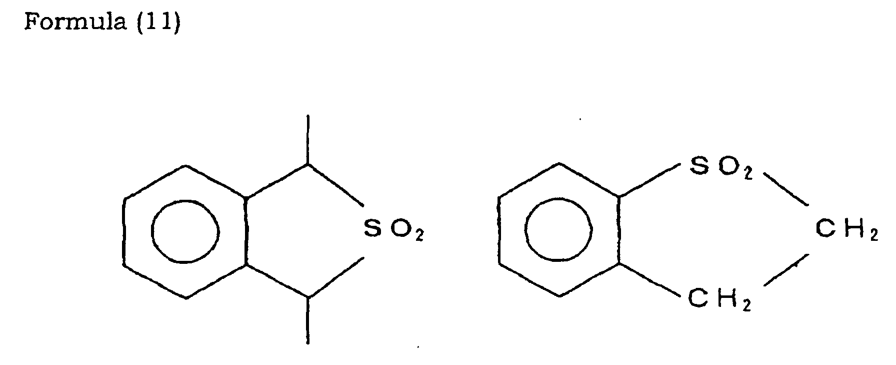

The compound of the above-mentioned formula (A-2) is an organic compound in which to specific two carbon atoms are bonded two sulfonyl groups or one sulfonyl group and one carbonyl group. Examples of the monovalent organic groups which are introduced as R⁴¹ and R⁴³ to the compound (A-2) are the same as the groups raised as the monovalent organic groups which are introduced to the above-mentioned compound (A-1). Also hydrogen atom of those organic groups may be replaced with at least one selected from the group consisting of halogen atom, nitro group and cyano group.

Examples of the above-mentioned compound (A-2) are bis(phenylsulfonyl)methane, bis(methylsulfonyl)methane, bis(ethylsulfonyl)methane, (methylsulfonyl)(phenylsulfonyl)methane, phenylsulfonyl acetophenone, methylsulfonyl acetophenone and the like.

In the compound (A-2), too, R⁴¹ and R⁴³ may be bonded to each other to form a ring. In that case, examples of the formed cyclic compound are, for instance, cyclic sulfone compounds represented by the following formula (12).

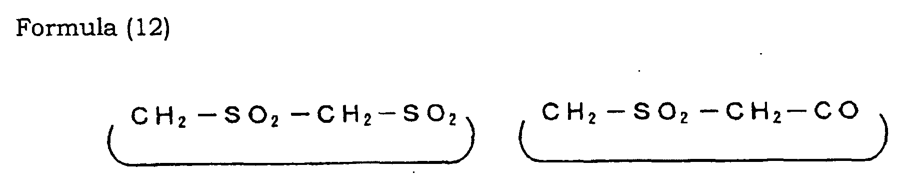

In the present invention, the above-mentioned compound (A-2) is a more preferred acid-generator because an alkali solubility and an efficiency of acid generation at exposing are high and sensitivity of a photo-sensitive composition (resist) is increased.

The above-mentioned compound (A-3) which is used as an acid-generator is an organic compound in which to a specific carbon atom are bonded at least two sulfonyl groups and further a linkage having sulfur and one carbonyl group. Examples of the monovalent organic groups which are introduced as R⁵¹, R⁵², R⁵³ and R⁵⁵ to the compound (A-3) are the same as the groups raised as the monovalent organic groups which are introduced to the above-mentioned compound (A-1). Further hydrogen atom of those organic groups may be replaced with at least one selected from the group consisting of halogen atom, nitro group and cyano group, hydroxyl, carboxyl or esterified carboxyl. Examples of preferred R⁵⁴ are sulfonyl group, sulfinyl group and sulfur atom.

Examples of the above-mentioned compound (A-3) are tris{phenylsulfonyl)methane, phenylthio-bis(phenylsulfonyl)-methane, phenylmercapto-bis(methylsulfonyl)-methane, tris(methylsulfonyl)methane, tris(ethylsulfonyl)methane, bis(phenylsulfonyl)-methylsulfonyl-methane, bis(methylsulfonyl)-phenylsulfonyl-methane, phenylsulfonyl-ethylsulfonyl-methylsulfonyl-methane, tris(4-nitophenylsulfonyl)methane, tris(2,4-nitrophenylsulfonyl)methane, bis(phenylsulfonyl)-(4-nitrophenylsulfonyl)-methane, bis(phenylsulfonyl)-(3-nitrophenylsulfonyl)-methane, bis(phenylsulfonyl)-(2-nitrophenylsulfonyl)-methane, bis(phenylsulfonyl)-(p-tolylsulfonyl)-methane, bis(methylsulfonyl)-(4-nitrophenylsulfonyl)-methane, bis(methylsulfonyl)-(4-chlorophenylsulfonyl)-methane, bis(phenylsulfonyl)-(4-chlorophenylsulfonyl)-methane, 1,1,1-tris(phenylsulfonyl)ethane and the like.

In the above-mentioned compounds (A-1), (A-2) and (A-3), it is preferable that, for example, at least one of R³¹, R⁴¹ and R⁴³ or at least one of R⁵¹, R⁵² and R⁵⁵ is an aromatic group from the point that particularly when exposing is carried out using excimer laser beam, dry etching resistivity and heat resistance of the photo-sensitive composition are enhanced. In addition, the acid-generators having a melting point of not less than 50°C and a high solubility in an organic solvent are also preferred.

On the other hand, when the compounds (A-1), (A-2) and (A-3) are the sulfonyl compounds having a basic substituent such as sulfone amide, there is a case where an acid generated by the exposing loses its activity. Also in case of a sulfonyl compound having an acid group having a high solubility in alkali such as sulfonic acid, there is a case where solubility in alkali at an un-exposed portion of the photo-sensitive composition is increased excessively. Therefore with respect to the sulfonyl compounds, there is a case where use thereof as an acid-generator in the composition is strictly limited in the present invention.

An adding amount of the acid-generator is preferably from 0.05 to 30 parts by weight, more preferably from 0.1 to 10 parts by weight based on 100 parts by weight of the whole photo-sensitive composition.

The reason for this is such that if the amount of the acid-generator is too small, an acid enough for initiating a catalytic reaction is not generated and therefore the catalytic reaction by the generated acid is not advanced and sufficient photosensitivity is hardly imparted to the photo-sensitive composition. On the other hand, if the amount is too large, a glass transition point and coatability of the photo-sensitive composition are lowered, which results in a fear that heat resistance and strength of the obtained resist pattern are lowered and a residue of the acid-generator is generated after the developing or after the etching.

Also if the adding amount thereof in the photo-sensitive composition is too large, particularly when the photo-sensitive composition is exposed to F2 excimer laser beam having a wavelength of 157 nm, since some of the above-mentioned acid-generators have a high absorption at a wavelength of exposure light, transmittance of beam through the photo-sensitive composition is significantly lowered and uniform exposing is difficult.

Those acid-generators may be used solely or in a mixture of two or more thereof.

In the chemically amplifying resist, there is known a method of controlling a distance of scattering an acid in the photo-sensitive composition and increasing resolution by adding a basic substance. In the photo-sensitive composition in the present invention, too, the same effect can be expected. In that case, an adding amount of the basic substance is preferably from 0.05 to 10 parts by weight, more preferably from 0.5 to 5 parts by weight based on 100 parts by weight of the acid-generator. If the amount is smaller than the above-mentioned amount, sufficient effect cannot be produced and on the contrary, if the amount is larger than the above-mentioned amount, much of the generated acid is neutralized and loses its action, and therefore sensitivity of the photo-sensitive composition is significantly lowered.

Then the solvent for the photo-sensitive composition of the present invention is explained below.

The photo-sensitive resin (photo-sensitive composition) which is used in the present invention can be prepared by dissolving, in a given solvent, an alkali soluble resin and a compound (acid-generator) which generates an acid by irradiating with energy rays such as F2 excimer laser beam.

The solvent is not limited particularly as far as it can be usually used as a solvent for a photo-sensitive composition. Non-limiting examples thereof are, for instance, ketone solvents such as cyclohexane, acetone, methyl ethyl ketone (2-butanone), methyl isobutyl ketone and 2-heptanone; cellosolve solvents such as methyl cellosolve, methyl cellosolve acetate, ethyl cellosolve and ethyl cellosolve acetate; ester solvents such as ethyl acetate, butyl acetate, isoamyl acetate, ethyl lactate and γ-butyrolactone; lactone solvents; glycol solvents such as propylene glycol monomethylether acetate (PGMEA); dimethyl sulfoxide; N-methylpyrrolidone; and the like.

Those solvents may be used solely or as a solvent mixture comprising two or more thereof.

The solvent mixture may contain a proper amount of, for example, aromatic hydrocarbon such as xylene or toluene, aliphatic alcohol such as ethanol and isopropyl alcohol (2-propanol) or a solvent derived therefrom.

Among the above-mentioned solvents, preferred is propylene glycol monomethylether acetate (PGMEA). Since a trace amount of the solvent remaining in the photo-sensitive composition affects characteristics of the photo-sensitive composition, PGMEA is suitable from the viewpoint of its boiling point, solubility parameter and polarity.

In addition to propylene glycol monomethylether acetate (PGMEA), ethyl lactate is also preferable as a solvent for the photo-sensitive composition.

Next, the method of forming a pattern of the present invention is explained by means of the drawing.

Mentioned below is the explanation in case where the photo-sensitive composition obtained from a fluorine-containing resin is used as a positive type resist.

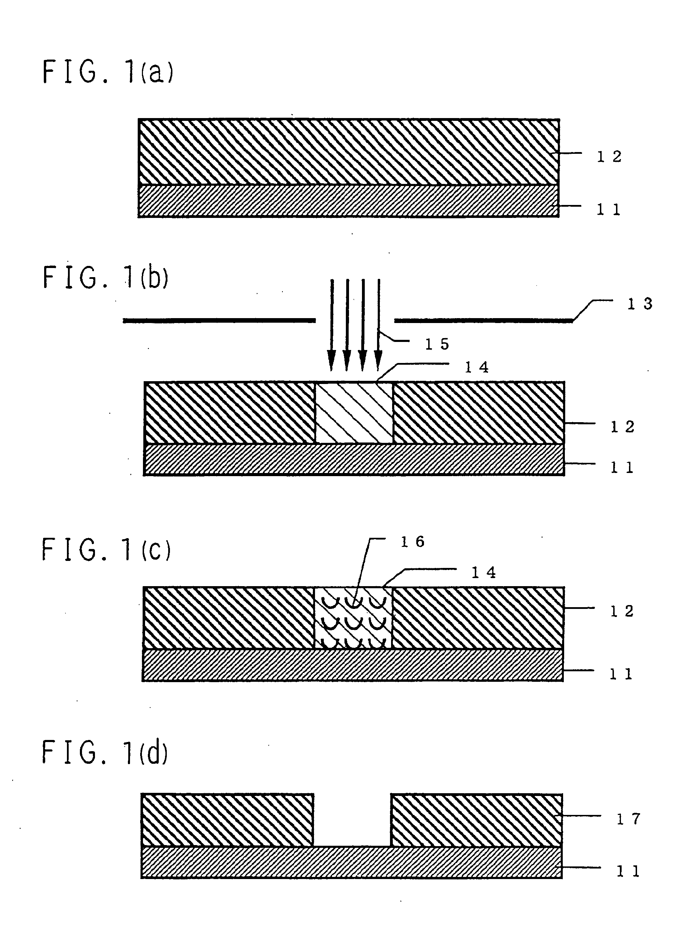

Fig. 1 is a cross-sectional view showing the method of forming the fine pattern of the present invention using the photo-sensitive composition obtained from a fluorine-containing resin.

First as shown in Fig. 1(a), the photo-sensitive composition obtained from a fluorine-containing resin is coated on a substrate 11 by a rotary coating method or the like in a coating thickness of from 0.01 to 5 µm, preferably from 0.05 to 0.5 µm, more preferably from 0.1 to 0.3 µm.

Next, pre-baking treatment is carried out at a temperature of not more than 150°C, preferably from 80° to 130°C to form a resin layer (layer of photo-sensitive composition), namely a resist layer 12.

Non-limiting examples of the above-mentioned substrate are, for instance, a silicon wafer, silicon wafer provided with various insulation films, electrode and wiring and having steps, mask blank, semiconductor wafer of III-V group compound such as GaAs and AlGaAs, semiconductor wafer of II-VI group compound, piezoelectric wafer of crystal, quartz or lithium tantalate and the like.

Then as shown in Fig. 1(b), a pattern is drawn on the resist layer 12 by irradiating energy rays such as F2 excimer laser beam as shown by an arrow 15 through a mask pattern 13 having a desired pattern and thus selectively exposing a specific area 14.

In that case, it is possible to generally use, as an exposure light, energy rays (or chemical radiation), namely X-ray, high energy electron beam, synchrotron radiation, characteristic radiation of high pressure mercury lamp, excimer laser beam other than F2 excimer laser beam or the like or to scan electron beam, ion beam or the like without using the mask to directly expose the resist film to the pattern. The effect of the present invention is exhibited most when F2 excimer laser beam is used as exposure light.

Subsequently by carrying out baking at a temperature of from 70° to 160°C, preferably from 90° to 140°C, for about 30 seconds to about 10 minutes after the exposing, a latent image 16 is formed on the exposed area 14 of the resist film as shown in Fig. 1(c). At that time, an acid generated by the exposing acts as a catalyst to decompose the dissolution-inhibiting group (dissolution inhibitor) and thereby solubility in alkali is increased and the exposed area of the resist film becomes soluble in an aqueous alkali solution.

Then when the resist film 12 subjected to the baking after the exposing is subjected to developing with an aqueous alkali solution, the un-exposed area of the resist film 12 remains on the substrate because its solubility in the aqueous alkali solution is low but the exposed area 14 is dissolved in the developing solution as mentioned above.

Next, after flowing away the developing solution with pure water, lower alcohol or a mixture thereof, the substrate is dried and thus a desired resist pattern 17 can be formed as shown in Fig. 1(d).

Mentioned above is the explanation in case of the positive type chemically amplifying resist, but also when the photo-sensitive composition is used on the negative type resist, since an acid generated by the exposing participates in the reaction of the alkali soluble resin with a crosslinking agent and also the reaction of making the resin insoluble in alkali by changing a structure of a substituent, there can be obtained such an effect that a pattern can be formed in high sensitivity like the case of positive type resist.

While the above-mentioned explanation is made with respect to the case of using F2 excimer laser beam as the energy ray, ArF excimer laser beam is also suitable as the energy ray used for the method of forming a fine pattern of the present invention.

Also KrF excimer laser beam is suitable as the energy ray used for the method of forming a fine pattern of the present invention.

High energy electron beam is also suitable as the energy ray used for the method of forming a fine pattern of the present invention.

Also high energy ion beam is suitable as the energy ray used for the method of forming a fine pattern of the present invention.

Also X-ray generated from synchrotron radiation is suitable as the energy ray used for the method of forming a fine pattern of the present invention.

Though the above-mentioned explanation is made with respect to the case of forming the resist film on the substrate 11, the formation of the resist film is not limited to the case of forming the resist film directly on a so-called substrate. The resist film may be formed on a substrate treated with an adhesion improver. The substrate is also not limited to those for production of semiconductor devices and includes various substrates for production of electronic devices, etc. as mentioned above. The resist film may also be formed on an electrically conductive film, insulating film or the like which is formed on the substrate. Also it is possible to form an antireflection film, for example, DUV-30, DUV-32, DUV-42 and DUV44 available from Brewer Science Co., Ltd. on the substrate and then form the resist film on the antireflection film.

Then explained below is a role of the antireflection film. When there is a step on the undercoat film formed on the substrate, there is a problem that exposure light is reflected on this step portion and a desired form of resist film cannot be obtained. To solve this problem, there is known a technology of providing an antireflection film on the top surface of the layer to be processed (undercoat layer) to prevent the reflection of exposure light. Namely, the antireflection film disclosed in USP4,910,122 is put under a photo-sensitive layer such as a photoresist layer and functions to eliminate a defect attributable to the reflection light. This antireflection film contains a light absorbing dye and is in the form of a uniform thin coating film. When this antireflection film is provided, the film absorbs light reflected from the undercoat layer and a sharp exposed photo-sensitive film pattern can be formed. A refraction of the antireflection film is generally demanded to be not more than 10 % and a suitable material therefor is one satisfying a complex index of refraction of 1.0<n<3.0 and 0.4<k<1.3.

Such an antireflection film is roughly classified into an inorganic film and organic film. When the inorganic film is used as an antireflection film, there are further two methods as a technology to prevent reflection. One is a method of controlling an ability of preventing reflection by controlling a thickness of the film prepared by using an inorganic material giving a film having the same refractive index irrespective of film forming conditions. The second method is a method of forming a film having a refractive index optimum for a substrate using an inorganic material of which refractive index varies depending on the film forming conditions and controlling an absorption and a phase by a coating thickness and a refractive index, thus preventing a reflection. Representative examples of the film material of the first method are TiN, TiON and the like, and representative examples of the film material of the second method are SiOxNy:H, SiO₂:H and the like. The second method of preventing a reflection is a method of making it possible to easily optimize a reflection-preventing action on the undercoat layer and obtain a great effect because a real part and imaginary part of a refractive index and further a coating thickness become parameters. The inorganic antireflection film is an excellent reflection preventing technology because a refractive index can be controlled by the film forming conditions and a standing wave can be reduced properly.

There are concretely, for example, an antireflection film obtained from TiN using a sputtering method and the like, a plasma SiN film formed by plasma CVD method, amorphous carbon (a-C:H) antireflection film formed by a chemical vapor deposition method (CVD method) or a sputtering method, and the like. The antireflection films formed by those vapor deposition methods have an advantage that even in case of a device having a high step or a small step, step coverage thereof is excellent.

The organic antireflection film is formed on a substrate using a liquid material by a spin coating method or a dip coating method but not by the above-mentioned vapor deposition method. Therefore since the organic antireflection film can be formed in the same manner as in the resist film, the formation of the antireflection film is easy and the thickness of the resist film tends to become uniform irrespective of steps. Therefore it is possible to inhibit a dimensional change caused by change in the thickness of the resist film.

The antireflection film obtained from an organic material generally comprises a base resin, light absorbing pigment, solvent and surfactant. The light absorbing pigment is contained in a trunk chain of the base resin, is present as a side chain of the resin or is present as a monomer in the solvent. Examples of the base resin are a novolak resin, polyvinyl phenol resin, a mixture thereof and a copolymer resin containing at least one of them. It is particularly preferable that the solution for forming the antireflection film is water soluble because a mixing layer is not formed. Preferred is a coating solution containing a water soluble film forming component because a mixing layer is not formed with the resist layer to be formed later. Examples of the above-mentioned water soluble film forming component are, for instance, cellulose polymers such as hydroxypropyl methyl cellulose phthalate, hydroxypropyl methyl cellulose acetate phthalate, hydroxypropyl methyl cellulose acetate succinate, hydroxypropyl methyl cellulose hexahydrophthalate, hydroxypropyl methyl cellulose, hydroxypropyl ethyl cellulose, hydroxypropyl cellulose, cellulose acetate hexahydrophthalate, carboxymethyl cellulose, ethyl cellulose and methyl cellulose; (meth)acrylate polymers comprising a monomer such as N,N-dimethylaminopropyl methacrylamide, N,N-dimethylaminopropyl acrylamide, N,N-dimethyl acrylamide, N,N-dimethylaminoethyl methacrylate, N,N-diethylaminoethyl methacrylate, N,N-dimethylaminoethyl acrylate, N-methylacrylamide, diacetoneacrylamide, acryloyl morpholine or acrylic acid; vinyl polymers such as polyvinyl alcohol and polyvinyl pyrrolidone and the like. Those film forming components may be used solely or in a mixture of two or more thereof. As the water soluble resin, in addition to polyvinyl alcohol, there are polysaccharides such as pullulan, polyvinyl pyrrolidone homopolymer and the like.

Any of the solvents can be used for the above-mentioned polymer solution without exception as far as they can dissolve the resin component therein. It is particularly preferable that the solvent is at least one selected from the group consisting of alcohol, aromatic hydrocarbon, ketone ester and ultra pure water.

There is a case where a surfactant is added to an antireflection film as a third component for enhancing a film forming property. Examples of the surfactant are betaine surfactants, amine oxide surfactants, amine carboxylate surfactants, polyoxyethylene alkyl ether surfactants and surfactants obtained by fluorine substitution thereof. An adding amount of the surfactant is desirably from 0 to 2 % by weight, particularly from 0 to 1 % by weight based on the whole aqueous solution.

It is desirable that the baking of the antireflection film is carried out in the air or in an oxygen atmosphere at a temperature of from 200° to 400°C for about 30 seconds to about 5 minutes. It is preferable that the coating thickness after the baking at high temperature is not more than 1,500 angstrom.

After the coating of the composition for forming the antireflection film, the film can be subjected to soft-baking to remove the solvent. It is desirable that the soft-baking is carried out at a temperature of from 100° to 250°C for about 30 seconds to about 5 minutes.

Also after the soft-baking step, a step for adjusting the film thickness can be carried out. This step for adjusting the film thickness can be conducted by removing the top of the film subjected to soft-baking using preferably at least one solvent selected from the group consisting of alcohol, aromatic hydrocarbon, ketone, ester and ultra pure water.

It is explained supra that when the antireflection film is not used, the photo-sensitive composition is coated directly on the substrate. In that case, examples of material of the substrate are SOG (Spin on Glass), SiN, SiON, A1, Ti, TiN, BPSG (boro-phospho silicate glass), chromium oxide, Pt and the like. As case demands, an undercoat film other than the antireflection film may be formed or the substrate may be subjected to oxygen plasma treatment or various surface treatments because in some cases, phenomena such as over-edging and dull-edging occur at the bottom of the pattern depending on kind of chemically amplifying resists.

Also when an intended fine pattern of an electrically conductive film or an insulating film is formed by using the so-formed fine resist pattern as a mask and etching a specific layer under the mask and then other steps are carried out, semiconductor devices and electronic devices can be produced. Since those steps are well known, explanation thereof is omitted.

The present invention is then explained by means of examples and comparative examples, but is not limited to them.

### PREPARATION EXAMPLE 1

### (Synthesis of copolymer of norbornene and tetrafluoroethylene)

A 100 ml autoclave equipped with a valve, pressure gauge and thermometer was charged with 5.6 g of 2-norbornene, 40 ml of HCFC-141b and 0.3 g of bis(4-tert-butylcyclohexyl)peroxydicarbonate (TCP), and while cooling with dry ice/methanol solution, the inside of a system was sufficiently replaced with nitrogen gas. Then 12.0 g of tetrafluoroethylene (TFE) was introduced through the valve, followed by shaking for reaction at 40°C for 18 hours. With the advance of the reaction, a gauge pressure was decreased from 9.8 kgf/cm²G before the reaction to 9.5 kgf/cm²G.

After releasing an un-reacted monomer, the polymerization solution was removed, followed by concentration and re-precipitation with methanol to separate a copolymer. Until a constant weight was reached, vacuum drying was continued and 5.7 g of the copolymer was obtained.

As a result of ¹H-NMR and ¹⁹F-NMR analyses, the copolymer was one comprising TFE/2-norbornene in a ratio of 50/SO %.

According to GPC analysis, a number average molecular weight of the copolymer was 3,400.

### PREPARATION EXAMPLE 2

### (Synthesis of copolymer of norbornene, tetrafluoroethylene and tert-butyl-αfluoroacrylate)

A 100 ml autoclave equipped with a valve, pressure gauge and thermometer was charged with 8.5 g of 2-norbornene, 1.9 g of tert-butyl-αfluoroacrylate, 40 ml of HCFC-141b and 0.5 g of bis(4-tert-butylcyclohexyl)peroxydicarbonate (TCP), and while cooling with dry ice/methanol solution, the inside of a system was sufficiently replaced with nitrogen gas. Then 15.0 g of tetrafluoroethylene (TFE) was introduced through the valve, followed by shaking for reaction at 40°C for 12 hours. With the advance of the reaction, a gauge pressure was decreased from 12.0 kgf/cm²G before the reaction to 10.5 kgf/cm²G.

After releasing an un-reacted monomer, the polymerization solution was removed, followed by concentration and re-precipitation with methanol to separate a copolymer. Until a constant weight was reached, vacuum drying was continued and 8.7 g of the copolymer was obtained.

As a result of ¹H-NMR and ¹⁹F-NMR analyses, the copolymer was one comprising TFE/2-norbomene/tert-butyl-αfluoroacrylate in a ratio of 32 / 57 / 11 % by mole.

According to GPC analysis, a number average molecular weight of the copolymer was 1,900.

### PREPARATION EXAMPLE 3

### (Synthesis of copolymer of norbornene, tetrafluoroethylene and tert-butyl-αfluoroacrylate)

A 100 ml autoclave equipped with a valve, pressure gauge and thermometer was charged with 12.0 g of 2-norbornene, 4.9 g of tert-butyl-αfluoroacrylate, 40 ml of HCFC-141b and 0.5 g of bis(4-tert-butylcyclohexyl)peroxydicarbonate (TCP), and while cooling with dry ice/methanol solution, the inside of a system was sufficiently replaced with nitrogen gas. Then 15.0 g of tetrafluoroethylene (TFE) was introduced through the valve, followed by shaking for reaction at 40°C for 12 hours. With the advance of the reaction, a gauge pressure was decreased from 12.0 kgf/cm²G before the reaction to 10.5 kgf/cm²G.

After releasing an un-reacted monomer, the polymerization solution was removed, followed by concentration and re-precipitation with methanol to separate a copolymer. Until a constant weight was reached, vacuum drying was continued and 5.5 g of the copolymer was obtained.

As a result of ¹H-NMR and ¹⁹F-NMR analyses, the copolymer was one comprising TFE/2-norbornene/tert-butyl-αfluoroacrylate in a ratio of 31/30/39 % by mole.

According to GPC analysis, a number average molecular weight of the copolymer was 4,300.

### PREPARATION EXAMPLE 4

### (Synthesis of copolymer of norbornene, tetrafluoroethylene and tert-butyl-αfluoroacrylate)

A 500 ml autoclave equipped with a valve, pressure gauge and thermometer was charged with 19.5 g of 2-norbornene, 17.0 g of tert-butyl-αfluoroacrylate, 240 ml of HCFC-141b and 1.3 g of bis(4-tert-butylcyclohexyl)peroxydicarbonate (TCP), and while cooling with dry ice/methanol solution, the inside of a system was sufficiently replaced with nitrogen gas. Then 56.0 g of tetrafluoroethylene (TFE) was introduced through the valve, followed by shaking for reaction at 40°C for 12 hours. With the advance of the reaction, a gauge pressure was decreased from 11.0 kgf/cm²G before the reaction to 10.2 kgf/cm²G.

After releasing an un-reacted monomer, the polymerization solution was removed, followed by concentration and re-precipitation with methanol to separate a copolymer. Until a constant weight was reached, vacuum drying was continued and 28.5 g of the copolymer was obtained.

As a result of ¹H-NMR and ¹⁹F-NMR analyses, the copolymer was one comprising TFE/2-norbornene/tert-butyl-afluoroacrylate in a ratio of 43/33/24 % by mole.

According to GPC analysis, a number average molecular weight of the copolymer was 32,000.

### PREPARATION EXAMPLE 5

### (Synthesis of copolymer of norbornene, tetrafluoroethylene and tert-butyl-αfluoroacrylate)

A 500 ml autoclave equipped with a valve, pressure gauge and thermometer was charged with 9.5 g of 2-norbornene, 13.7 g of tert-butyl-αfluoroacrylate, 240 ml of HCFC-141b and 1.5 g of bis(4-tert-butylcyclohexyl)peroxydicarbonate (TCP), and while cooling with dry ice/methanol solution, the inside of a system was sufficiently replaced with nitrogen gas. Then 18.0 g of tetrafluoroethylene (TFE) was introduced through the valve, followed by shaking for reaction at 40°C for 12 hours. With the advance of the reaction, a gauge pressure was decreased from 12.0 kgf/cm²G before the reaction to 10.5 kgf/cm²G.

After releasing an un-reacted monomer, the polymerization solution was removed, followed by concentration and re-precipitation with hexane to separate a copolymer. Until a constant weight was reached, vacuum drying was continued and 19.5 g of the copolymer was obtained.

As a result of ¹H-NMR and ¹⁹F-NMR analyses, the copolymer was one comprising TFE/2-norbornene/tert-butyl-afluoroacrylate in a ratio of 13/22/65 % by mole.

According to GPC analysis, a number average molecular weight of the copolymer was 25,000.

### PREPARATION EXAMPLE 6

### (Synthesis of copolymer of norbornene, tetrafluoroethylene and tert-butyl-αfluoroacrylate)

A 500 ml autoclave equipped with a valve, pressure gauge and thermometer was charged with 19.7 g of 2-norbornene, 16.9 g of tert-butyl-αfluoroacrylate, 240 ml of HCFC-141b and 1.3 g of bis(4-tert-butylcyclohexyl)peroxydicarbonate (TCP), and while cooling with dry ice/methanol solution, the inside of a system was sufficiently replaced with nitrogen gas. Then 56.0 g of tetrafluoroethylene (TFE) was introduced through the valve, followed by shaking for reaction at 40°C for 12 hours. With the advance of the reaction, a gauge pressure was decreased from 10.1 kgf/ cm²G before the reaction to 9.5 kgf/ cm²G.

After releasing an un-reacted monomer, the polymerization solution was removed, followed by concentration and re-precipitation with hexane to separate a copolymer. Until a constant weight was reached after the re-precipitation, vacuum drying was continued and 23.5 g of the copolymer was obtained.

As a result of ¹H-NMR and ¹⁹F-NMR analyses, the copolymer was one comprising TFE/2-norbornene/tert-butyl-αfluoroacrylate in a ratio of 11/ 19/70 % by mole.

According to GPC analysis, a number average molecular weight of the copolymer was 31,000.

### PREPARATION EXAMPLE 7

### (Deprotection of copolymer obtained in Preparation Example 6)

In a 100 ml egg-plant flask, 1.8 g of the copolymer of norbornene, tetrafluoroethylene and tert-butyl-αfluoroacrylate obtained in Preparation Example 6 was dissolved in 80 g of methylene chloride, and thereto was added 1.2 g of trifluoroacetic acid, followed by stirring at room temperature for 12 hours. After the reaction, excessive amounts of trifluoroacetic acid and methylene chloride were distilled off under reduced pressure. The remaining solid component was washed with distilled water several times, dissolved in tetrahydrofuran and then reprecipitated with hexane to separate a copolymer. As a result of ¹H-NMR and ¹⁹F-NMR analyses, the copolymer was one comprising TFE/2-norbornene/tert-butyl-αfluoroacrylate/αfluoroacrylic acid in a ratio of 11 / 19 / 66/ 4 % by mole.

### PREPARATION EXAMPLE 8

### (Synthesis of copolymer of norbornene, tetrafluoroethylene and tert-butyl-αfluoroacrylate)

A 500 ml autoclave equipped with a valve, pressure gauge and thermometer was charged with 10.7 g of 2-norbornene, 16.9 g of tert-butyl-αfluoroacrylate, 240 ml of HCFC-141b and 1.3 g of bis(4-tert-butylcyclohexyl)peroxydicarbonate (TCP), and while cooling with dry ice/methanol solution, the inside of a system was sufficiently replaced with nitrogen gas. Then 22.0 g of tetrafluoroethylene (TFE) was introduced through the valve, followed by shaking for reaction at 40°C for 12 hours. With the advance of the reaction, a gauge pressure was decreased from 6.2 kgf/cm²G before the reaction to 5.5 kgf/cm²G.

After releasing an un-reacted monomer, the polymerization solution was removed, followed by concentration and re-precipitation with hexane to separate a copolymer. Until a constant weight was reached after the re-precipitation, vacuum drying was continued and 23.5 g of the copolymer was obtained.

As a result of ¹H-NMR and ¹⁹F-NMR analyses, the copolymer was one comprising TFE/2-norbornene/tert-butyl-αfluoroacrylate in a ratio of 19/22/59 % by mole.

According to GPC analysis, a number average molecular weight of the copolymer was 17,000.

### PREPARATION EXAMPLE 9

### (Deprotection of copolymer obtained in Preparation Example 8)

In a 100 ml egg-plant flask, 5.0 g of the copolymer of norbornene, tetrafluoroethylene and tert-butyl-αfluoroacrylate obtained in Preparation Example 8 was dissolved in 80 g of methylene chloride, and thereto was added 4.0 g of trifluoroacetic acid, followed by stirring at 40°C for 8 hours. After the reaction, excessive amounts of trifluoroacetic acid and methylene chloride were distilled off under reduced pressure. The remaining solid component was washed with distilled water several times, dissolved in tetrahydrofuran and then reprecipitated with hexane to separate a copolymer. As a result of ¹H-NMR and ¹⁹F-NMR analyses, the copolymer was one comprising TFE/2-norbornene/tert-butyl-αfluoroacrylate/αfluoroacrylic acid in a ratio of 19/22/41/18 % by mole.

### PREPARATION EXAMPLE 10

### (Synthesis of copolymer of norbornene, tetrafluoroethylene and fluorine-containing allyl ether having COOH group)

A 100 ml autoclave equipped with a valve, pressure gauge and thermometer was charged with 5.6 g of 2-norbornene, 10.9 g of perfluoro(9,9-dihydro-2,5-bistrifluoromethyl-3,6-dioxa-8-nonenoic acid): 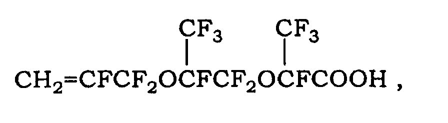 40 ml of HCFC-141b and 0.3 g of bis(4-tert-butylcyclohexyl)peroxydicarbonate (TCP), and while cooling with dry ice/methanol solution, the inside of a system was sufficiently replaced with nitrogen gas. Then 12.0 g of tetrafluoroethylene (TFE) was introduced through the valve, followed by shaking for reaction at 40°C for 12 hours. With the advance of the reaction, a gauge pressure was decreased from 10.1 kgf/cm²G before the reaction to 9.5 kgf/cm²G.

After releasing an un-reacted monomer, the polymerization solution was removed, followed by concentration and re-precipitation with methanol to separate a copolymer. Until a constant weight was reached, vacuum drying was continued and 4.5 g of the copolymer was obtained.

As a result of ¹H-NMR and ¹⁹F-NMR analyses, the copolymer was one comprising TFE/2-norbornene/fluorine-containing allyl ether in a ratio of 30/54/16 % by mole.

According to GPC analysis, a number average molecular weight of the copolymer was 3,800.

### PREPARATION EXAMPLE 11

### (Synthesis of copolymer of norbornene, tetrafluoroethylene and fluorine-containing allyl ether having -COOC(CH₃)₃ group)

A 100 ml autoclave equipped with a valve, pressure gauge and thermometer was charged with 5.6 g of 2-norbornene, 4.9 g of perfluoro(9,9-dihydro-2,5-bistrifluoromethyl-3,6-dioxa-8-nonenoic acid-tert-butyl ester): 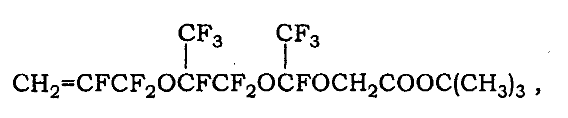 40 ml of HCFC-141b and 0.3 g of bis(4-tert-butylcyclohexyl)peroxydicarbonate (TCP), and while cooling with dry ice/methanol solution, the inside of a system was sufficiently replaced with nitrogen gas. Then 12.0 g of tetrafluoroethylene (TFE) was introduced through the valve, followed by shaking for reaction at 40°C for 12 hours. With the advance of the reaction, a gauge pressure was decreased from 9.1 kgf/ cm²G before the reaction to 8.5 kgf/ cm²G.

After releasing an un-reacted monomer, the polymerization solution was removed, followed by concentration and re-precipitation with methanol to separate a copolymer. Until a constant weight was reached, vacuum drying was continued and 5.5 g of the copolymer was obtained.

As a result of ¹H-NMR and ¹⁹F-NMR analyses, the copolymer was one comprising TFE/2-norbornene/fluorine-containing allyl ether in a ratio of 55/37/8 % by mole.

According to GPC analysis, a number average molecular weight of the copolymer was 4,500.

### PREPARATION EXAMPLE 12

### (Synthesis of copolymer of norbornene, tetrafluoroethylene and fluorine-containing allyl ether having -COOC(GH₃)₃ group)

A 100 ml autoclave equipped with a valve, pressure gauge and thermometer was charged with 5.6 g of 2-norbornene, 11.9 g of perfluoro(9,9-dihydro-2,5-bistrifluoromethyl-3,6-dioxa-8-nonenoic acid-tert-butyl ester): 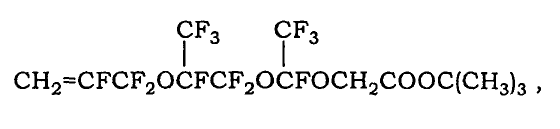 40 ml of HCFC-141b and 0.3 g of bis(4-tert-butylcyclohexyl)peroxydicarbonate (TCP), and while cooling with dry ice/methanol solution, the inside of a system was sufficiently replaced with nitrogen gas. Then 12.0 g of tetrafluoroethylene (TFE) was introduced through the valve, followed by shaking for reaction at 40°C for 12 hours. With the advance of the reaction, a gauge pressure was decreased from 8.6 kgf/cm²G before the reaction to 8.0 kgf/cm²G.

After releasing an un-reacted monomer, the polymerization solution was removed, followed by concentration and re-precipitation with methanol to separate a copolymer. Until a constant weight was reached, vacuum drying was continued and 4.5 g of the copolymer was obtained.

As a result of ¹H-NMR and ¹⁹F-NMR analyses, the copolymer was one comprising TFE/2-norbomene/fluorine-containing allyl ether in a ratio of 47/40/13 % by mole.

According to GPC analysis, a number average molecular weight of the copolymer was 4,400.

### PREPARATION EXAMPLE 13

### (Synthesis of copolymer of norbornene, tetrafluoroethylene and fluorine-containing norbornene having -COOC(CH₃)₃ group)

A 100 ml autoclave equipped with a valve, pressure gauge and thermometer was charged with 9.0 g of 2-norbornene, 5.1 g of fluorine-containing norbornene having -COOC(CH₃)₃ group: 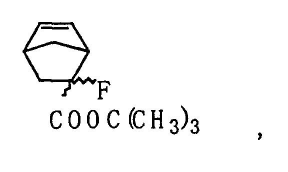 40 ml of HCFC-141b and 0.3 g of bis(4-tert-butylcyclohexyl)peroxydicarbonate (TCP), and while cooling with dry ice/methanol solution, the inside of a system was sufficiently replaced with nitrogen gas. Then 12.0 g of tetrafluoroethylene (TFE) was introduced through the valve, followed by shaking for reaction at 40°C for 12 hours. With the advance of the reaction, a gauge pressure was decreased from 9.6 kgf/ cm²G before the reaction to 9.0 kgf/cm²G.

After releasing an un-reacted monomer, the polymerization solution was removed, followed by concentration and re-precipitation with methanol to separate a copolymer. Until a constant weight was reached, vacuum drying was continued and 2.2 g of the copolymer was obtained.

As a result of ¹H-NMR and ¹⁹F-NMR analyses, the copolymer was one comprising TFE/2-norbomene/fluorine-containing norbornene in a ratio of 54/37/9 % by mole.

According to GPC analysis, a number average molecular weight of the copolymer was 1,200.

### PREPARATION EXAMPLE 14

### (Synthesis of copolymer of norbornene, tetrafluoroethylene and fluorine-containing norbornene having -COOC(CH₃)₃ group)

A 100 ml autoclave equipped with a valve, pressure gauge and thermometer was charged with 2.8 g of 2-norbornene, 6.3 g of fluorine-containing norbornene having -COOC(CH₃)₃ group: 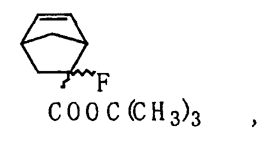 40 ml of HCFC-141b and 0.3 g of bis(4-tert-butylcyclohexyl)peroxydicarbonate (TCP), and while cooling with dry ice/methanol solution, the inside of a system was sufficiently replaced with nitrogen gas. Then 12.0 g of tetrafluoroethylene (TFE) was introduced through the valve, followed by shaking for reaction at 40°C for 12 hours. With the advance of the reaction, a gauge pressure was decreased from 9.6 kgf/cm²G before the reaction to 9.2 kgf/cm²G.

After releasing an un-reacted monomer, the polymerization solution was removed, followed by concentration and re-precipitation with methanol to separate a copolymer. Until a constant weight was reached, vacuum drying was continued and 2.1 g of the copolymer was obtained.

As a result of ¹H-NMR and ¹⁹F-NMR analyses, the copolymer was one comprising TFE/2-norbornene/fluorine-containing norbornene in a ratio of 58/27/15 % by mole.

According to GPC analysis, a number average molecular weight of the copolymer was 5,300.

### PREPARATION EXAMPLE 15

### (Synthesis of copolymer of norbornene, tetrafluoroethylene and fluorine-containing norbornene having -COOC(CH₃)₃ group)

A 500 ml autoclave equipped with a valve, pressure gauge and thermometer was charged with 40.8 g of 2-norbornene, 71.3 g of fluorine-containing norbornene having -COOC(CH₃)₃ group: 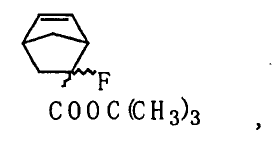 240 ml of HCFC-141b and 1.5 g of bis(4-tert-butylcyclohexyl)peroxydicarbonate (TCP), and while cooling with dry ice/methanol solution, the inside of a system was sufficiently replaced with nitrogen gas. Then 56.0 g of tetrafluoroethylene (TFE) was introduced through the valve, followed by shaking for reaction at 40°C for 12 hours. With the advance of the reaction, a gauge pressure was decreased from 9.8 kgf/ cm ²G before the reaction to 9.2 kgf/ cm²G.

After releasing an un-reacted monomer, the polymerization solution was removed, followed by concentration and re-precipitation with methanol to separate a copolymer. Until a constant weight was reached, vacuum drying was continued and 10.1 g of the copolymer was obtained.

As a result of ¹H-NMR and ¹⁹F-NMR analyses, the copolymer was one comprising TFE/2-norbornene/fluorine-containing norbornene in a ratio of 56/31/13 % by mole.

According to GPC analysis, a number average molecular weight of the copolymer was 2,300.

### PREPARATION EXAMPLE 16

### (Synthesis of copolymer of norbornene, tetrafluoroethylene and fluorine-containing norbornene having -COOC(CH₃)₃ group)

A 500 ml autoclave equipped with a valve, pressure gauge and thermometer was charged with 11.8 g of 2-norbornene, 79.3 g of fluorine-containing norbornene having -COOC(CH₃)₃ group: 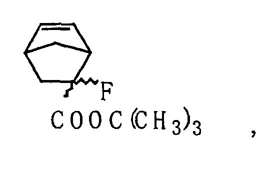 240 ml of HCFC-141b and 3.5 g of bis(4-tert-butylcyclohexyl)peroxydicarbonate (TCP), and while cooling with dry ice/methanol solution, the inside of a system was sufficiently replaced with nitrogen gas. Then 50.0 g of tetrafluoroethylene (TFE) was introduced through the valve, followed by shaking for reaction at 40°C for 12 hours. With the advance of the reaction, a gauge pressure was decreased from 9.8 kgf/cm²G before the reaction to 9.2 kgf/cm²G.

After releasing an un-reacted monomer, the polymerization solution was removed, followed by concentration and re-precipitation with methanol to separate a copolymer. Until a constant weight was reached, vacuum drying was continued and 12.1 g of the copolymer was obtained.

As a result of ¹H-NMR and ¹⁹F-NMR analyses, the copolymer was one comprising TFE/2-norbornene/fluorine-containing norbornene in a ratio of 56 / 13 / 31 % by mole.

According to GPC analysis, a number average molecular weight of the copolymer was 4,600.

### PREPARATION EXAMPLE 17

### (Synthesis of copolymer of tetrafluoroethylene and fluorine-containing norbornene having -COOC(CH₃)₃ group)

A 300 ml autoclave equipped with a valve, pressure gauge and thermometer was charged with 15.9 g of fluorine-containing norbornene having -COOC(CH₃)₃ group: 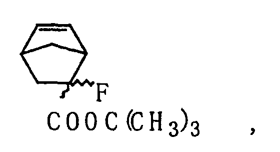 140 ml of HCFC-141b and 1.5 g of bis(4-tert-butylcyclohexyl)peroxydicarbonate (TCP), and while cooling with dry ice/methanol solution, the inside of a system was sufficiently replaced with nitrogen gas. Then 30.0 g of tetrafluoroethylene (TFE) was introduced through the valve, followed by shaking for reaction at 40°C for 12 hours. With the advance of the reaction, a gauge pressure was decreased from 9.6 kgf/cm²G before the reaction to 9.3 kgf/cm²G.

After releasing an un-reacted monomer, the polymerization solution was removed, followed by concentration and re-precipitation with methanol to separate a copolymer. Until a constant weight was reached, vacuum drying was continued and 4.1 g of the copolymer was obtained.

As a result of ¹H-NMR and ¹⁹F-NMR analyses, the copolymer was one comprising TFE/fluorine-containing norbornene in a ratio of 50/50 % by mole.

According to GPC analysis, a number average molecular weight of the copolymer was 2,500.

### PREPARATION EXAMPLE 18

### (Synthesis of copolymer of norbornene, tetrafluoroethylene and fluorine-containing oxonorbornene having -COOC(CH₃)₃ group)

A 100 ml autoclave equipped with a valve, pressure gauge and thermometer was charged with 7.0 g of 2-norbornene, 4.1 g of fluorine-containing oxonorbomene having -COOC(CH₃)₃ group: 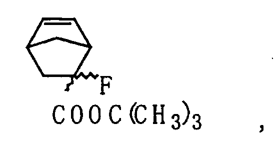 40 ml of HCFC-141 b and 0.3 g of bis(4-tert-butylcyclohexyl)peroxydicarbonate (TCP), and while cooling with dry ice/methanol solution, the inside of a system was sufficiently replaced with nitrogen gas. Then 12.0 g of tetrafluoroethylene (TFE) was introduced through the valve, followed by shaking for reaction at 40°C for 12 hours. With the advance of the reaction, a gauge pressure was decreased from 9.8 kgf/cm²G before the reaction to 9.2 kgf/cm²G.

After releasing an un-reacted monomer, the polymerization solution was removed, followed by concentration and re-precipitation with methanol to separate a copolymer. Until a constant weight was reached, vacuum drying was continued and 1.1 g of the copolymer was obtained.

As a result of ¹H-NMR and ¹⁹F-NMR analyses, the copolymer was one comprising TFE/2-norbornene/fluorine-containing oxonorbornene in a ratio of 48/33/ 19 % by mole.

According to GPC analysis, a number average molecular weight of the copolymer was 2,500.

### PREPARATION EXAMPLE 19

### (Synthesis of copolymer of norbornene, tetrafluoroethylene and fluorine-containing oxonorbomene having -COOC(CH₃)₃ group)

A 100 ml autoclave equipped with a valve, pressure gauge and thermometer was charged with 5.6 g of 2-norbornene, 3.0 g of fluorine-containing oxonorbornene having -COOC(CH₃)₃ group: 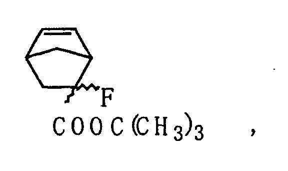 40 ml of HCFC-141b and 0.3 g of bis(4-tert-butylcyclohexyl)peroxydicarbonate (TCP), and while cooling with dry ice/methanol solution, the inside of a system was sufficiently replaced with nitrogen gas. Then 12.0 g of tetrafluoroethylene (TFE) was introduced through the valve, followed by shaking for reaction at 40°C for 12 hours. With the advance of the reaction, a gauge pressure was decreased from 9.8 kgf/ cm²G before the reaction to 9.2 kgf/ cm²G.

After releasing an un-reacted monomer, the polymerization solution was removed, followed by concentration and re-precipitation with methanol to separate a copolymer. Until a constant weight was reached, vacuum drying was continued and 1.5 g of the copolymer was obtained.

As a result of ¹H-NMR and ¹⁹F-NMR analyses, the copolymer was one comprising TFE/2-norbomene/fluorine-containing oxonorbornene in a ratio of 58/32/ 10 % by mole.

According to GPC analysis, a number average molecular weight of the copolymer was 2,300.

### EXAMPLE 1

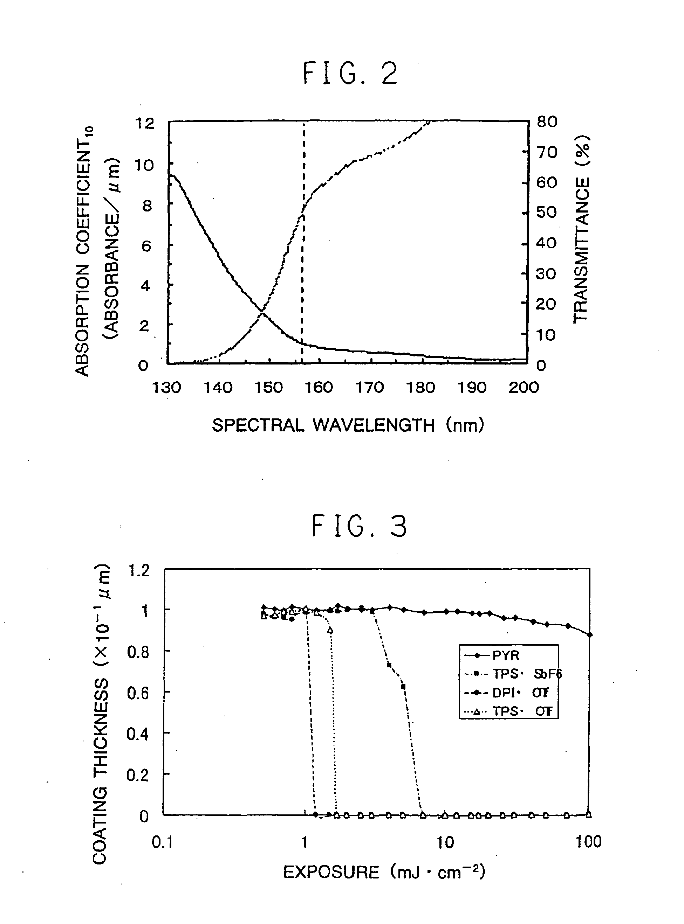

A vacuum ultraviolet absorption spectrum of the fluorine-containing copolymer obtained in Preparation Example 11 is shown in Fig. 2. An absorption coefficient at 157 nm is 0.93 per 1 µm and transparency at 157 nm is high as compared with a polymer of Comparative Example 1 having no fluorine.

### EXAMPLE 2

Table 1 shows an absorption coefficient at 157 nm of high molecular weight materials having fluorine in a molecular structure thereof. An absorption coefficient at 157 nm is significantly lowered as compared with a material of Comparative Example 1 not having fluorine and transparency is greatly enhanced. As a result, 10 % or more of transmittance at 300 nm could be obtained.

**TABLE 1**

| | Absorption coefficient / µm⁻¹ | Transmittance T at 300 nm |
|---|---|---|
| PAEH102 | 0.03 | 97.8 % |
| PAEH002 | 0.04 | 97.5 % |
| PAEH001 | 0.06 | 95.9 % |
| PAEH101 | 0. 09 | 94.1 % |
| PAEH001 | 0.10 | 93.2 % |
| PAEV001 | 0.11 | 92.9 % |
| PAEHC111 | 0.11 | 92. 7 % |
| PAEH102 | 0.14 | 90.7 % |
| PAEH101 | 0.14 | 90.7 % |
| PAEVH011 | 0.17 | 88.9% |
| PETE-001 | 0.20 | 87.1 % |
| PAEH002 | 0.22 | 85.7% |
| PAEHC112 | 0.28 | 82.4 % |
| LC-700 | 0.33 | 79.6 % |
| PAEHCTB110 | 0.34 | 79.1 % |
| VP-100 | 0.39 | 76.4 % |
| PAEHC111 | 0.63 | 64.8 % |
| PTHP-001 | 0.75 | 59.6 % |
| PAEHTB110 | 0.92 | 53.0 % |
| PTNbAEC-002 | 0.93 | 52.6 % |
| PVAEC021 | 0.95 | 51.9 % |
| PTNbAEC-003 | 1.00 | 50.1 % |
| PTNb005 | 1.01 | 49.8 % |
| PTNbAEC-001 | 1.11 | 46.5 % |
| PAEHC112 | 1.11 | 46.4 % |
| PVAEC022 | 1.17 | 44.6 % |
| PTAEC001 | 1.25 | 42.2 % |
| PHB-001 | 1.30 | 40.7 % |
| PTNb004 | 1.31 | 40.5 % |
| PAEHC113 | 1.31 | 40.4 % |
| PAEHC114 | 1.33 | 40.0 % |
| PTHCB-002 | 1.43 | 37.2 % |
| PCCTB002 | 1.43 | 37.2 % |
| PCCTB003 | 1.59 | 33.3 % |
| PTHCB-001 | 1.60 | 33.1 % |
| PTHHB-001 | 1.60 | 33.1 % |
| PCCTB001 | 1.60 | 33.1 % |
| PTNbC-006 | 1.70 | 30.9 % |
| PCB-001 | 1.74 | 30.1 % |
| PAEC010 | 1.82 | 28.4 % |
| PTNbC-002 | 1.92 | 26.5 % |
| PTNbC010 | 2.00 | 25.1 % |
| PTNbC-005 | 2.10 | 23.4 % |
| PTNbC009 | 2.10 | 23.4 % |
| PTNbC-001 | 2.20 | 21.9 % |
| PTNbC-007 | 2.23 | 21.4 % |
| PTNb006 | 2.30 | 20.4 % |
| PTNbC-003 | 2.44 | 18.5 % |
| PTNbC-008 | 2.53 | 17.4 % |
| PTNb001 | 2.77 | 14.8 % |
| GK-510 | 2.92 | 13.3 % |

In Table 1, abbreviations of high molecular weight materials represent the following compounds.

| | |
|---|---|
| PAEH102 | AEH1 homopolymer |
| PAEH002 | AEHO homopolymer |
| PAEH001 | AEHO homopolymer |
| PAEH101 | AEH1 homopolymer |
| PAEH001 | AEHO homopolymer |
| PAEV001 | AEV homopolymer |
| PAEHC11 | AEH1/AEC1=82/ 18 (% by mole, hereinafter the same) |
| PAEH102 | AEH1 homopolymer |
| PAEH101 | AEH1 homopolymer |
| PAEVH011 | AEH1/AEV=35/65 |
| PETE-001 | AEH1/ETE homopolymer |
| PAEH002 | AEHO homopolymer |
| PAEHC112 | AEH1/AEC1=62/38 |
| LC-700 | Vinylidene copolymer (trade name) |
| PAEHCTB110 | AEH1/AEC1-tBu=75/25 |
| VP-100 | Vinylidene copolymer |
| PAEHC11 | AEH1/AEC1=82/ 18 |
| PTHP-001 | AEH1-THP homopolymer |
| PAEHTB110 | AEH1/AEC2-tBu=50/50 |
| PTNbAEC-002 | TFE/Nb/AEC-Bu-t=55/37/8 |
| PVAEC021 | VdF/AEC1=75/25 |
| PTNbAEC-003 | TFE/Nb/AEC-Bu-t=47/40/13 |
| PTNb005 | TFE/Nb/α-FAc=58/27/15 |
| PTNbAEC-001 | TFE/Nb/AEC=30/54/16 |
| PAEHC112 | AEH1/AEC1=62/38 |
| PVAEC022 | VdF/AEC1=40/60 |
| PTAEC001 | TFE/AEC1=50/50 |
| PHB-001 | AEHB homopolymer |
| PTNb004 | TFE/Nb=50/50 |
| PAEHC113 | AEH1/AEC1=54/46 |
| PAEHC114 | AEH1/AEC1=70/30 |
| PTHCB-002 | AEH1-THP/AEC1-tBu=25/75 |
| PCCTB002 | AEC1/AEC1-tBu=50/50 |
| PCCTB003 | AEC1/AEC1-tBu=25/75 |
| PTHCB-001 | AEH1-THP/AEC1-tBu=50/50 |
| PTHHB-001 | AEH1-THP/AEHB=50/50 |
| PCCTB001 | AEC1/AEC1-tBu=75/25 |
| PTNbC-006 | TFE/Nb/α-FAc=43/33/24 |
| PCB-001 | AEC1-tBu homopolymer |
| PAEC010 | AEC homopolymer |
| PTNbC-002 | TFE/Nb/Nb(F)COOBu=54/37/9 |
| PTNbC010 | TFE/Nb/oxo-Nb(F)COOBu=56/32/12 |
| PTNbC-005 | TFE/Nb/Nb(F)COOBu=58/27/15 |
| PTNbC009 | TFE/Nb/Nb(F)COOBu=62/25/13 |
| PTNbC-001 | TFE/Nb/NbCOOH=41/50/9 |
| PTNbC-007 | TFE/Nb/Nb(F)COOBu=56/31/13 |
| PTNb006 | TFE/Nb/oxo-Nb(F)COOBu=58/32/ 10 |
| PTNbC-003 | TFE/Nb/oxo-Nb(F)COOBu=48/33/19 |
| PTNbC-008 | TFE/Nb/oxo-Nb(F)COOBu=40/40/20 |
| PTNb001 | TFE/Nb=50/50 |
| GK-510 | TFE/vinyl ether copolymer (trade name) |

Abbreviations of the above-mentioned compounds represent the following compounds.
TFE: Tetrafluoroethylene CF₂=CF₂
Nb: 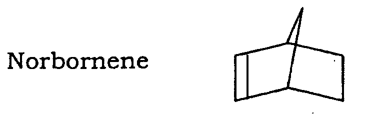
α-FAc: 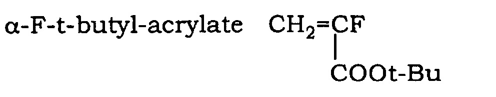
AEC-Bu-t: 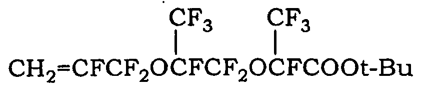
AEC: 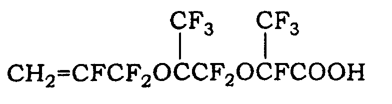
Nb(F)COOBu: 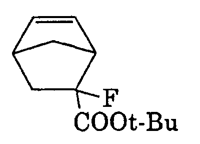
oxo-Nb(F)COOBu: 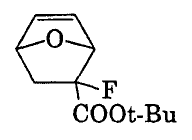
NbCOOH: 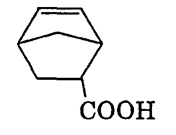
AEHI: 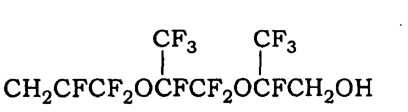
AEHO: 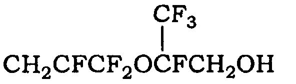
AEV: CH₂=CFCF₂OCF=CF₂
AEHI-ETE: 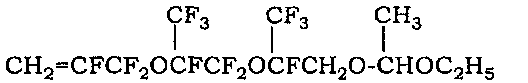
AECI-tBu: 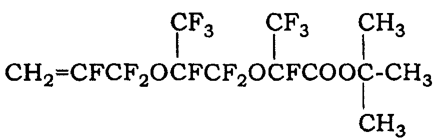
AEHI-THP: 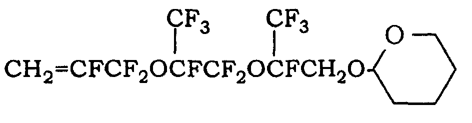
VdF: CH₂=CF₂
AEHB: 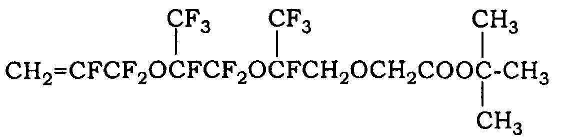
AEC2-tBu:

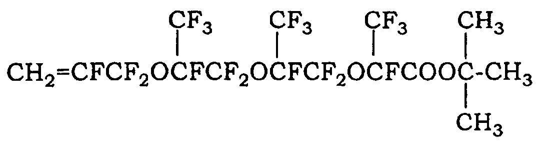

### COMPARATIVE EXAMPLE 1

Absorption coefficients at 157 nm of high molecular weight materials having no fluorine in a molecular structure thereof are shown in Table 2. The absorption coefficients of those resins are 4 or more per 1 µm and transmission at 300 nm is less than 5 %.

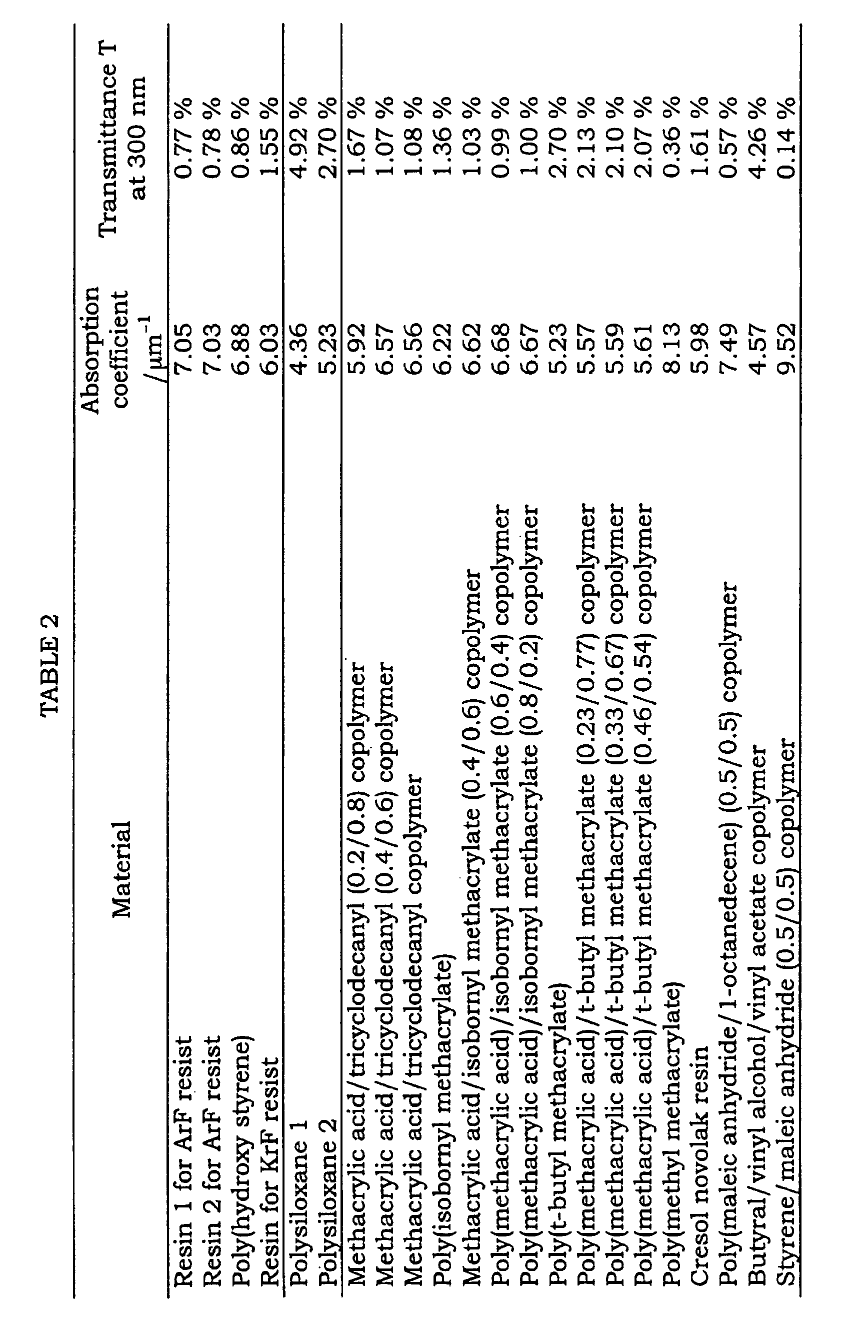

The respective names of the high molecular weight materials in Table 2 are mentioned below.
Resin 1 for ArF resist: 2-Methyl 2-adamantyl methacrylate/mevalonic lactone methacrylate copolymer
Resin 2 for ArF resist: 2-Methyl 2-adamantyl methacrylate/γ-butyrolactone methacrylate copolymer
Resin for KrF resist: Partially t-BOC-protected polyhydroxy styrene
Polysiloxane 1: (Polydimethylsilsesquioxane)
Polysiloxane 2: (Polydiphenylsilsesquioxane)

In Table 2, figures in the parentheses represent copolymerization ratios (% by mole).

### EXAMPLE 3

To 100 parts by weight of the fluorine-containing copolymer obtained in Preparation Example 5 was added 5 parts by weight of triphenylsulfonium triflate as a photoactive acid generator, followed by dissolving in propyleneglycol monomethylether acetate (PGMEA) to prepare a solution of photo-sensitive composition. Then the solution was coated on a silicon wafer with a spinner and was dried at 110°C for 60 seconds to form a 0.1 µm thick resist film.

The resist film was subjected to exposing with F2 excimer laser beam (wavelength: 157 nm) and after the exposing, the film was subjected to heating at 120°C for 60 seconds on a heated plate and then developing with an aqueous solution of tetramethylammonium hydroxide (TMAH) having a concentration of 2.38 % by weight.

A thickness of the photo-sensitive composition film remaining after the developing is shown in Fig. 3.

The structures of the photoactive acid generators are as shown in the following formula (13).

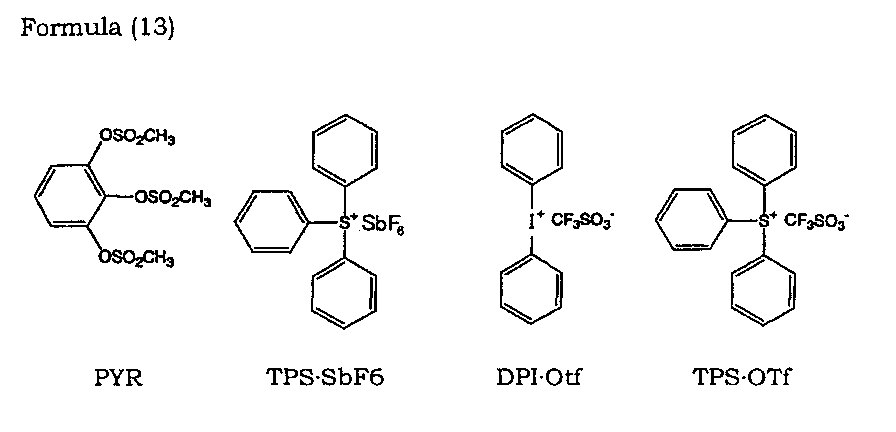

In the photo-sensitive composition to which PYR was added, water repellency was high and the developing was not proceeded sufficiently. On the other hand, in the photo-sensitive compositions to which other acid-generators were added, there was a change in a dissolution characteristic in response to an amount of exposure light.

### EXAMPLE 4

To 100 parts by weight of the fluorine-containing copolymer obtained in Preparation Example 5 was added 5 parts by weight of triphenylsulfonium triflate as a photoactive acid generator. The obtained photo-sensitive composition was dissolved in chlorobenzene (PhCl), ethyl lactate (EL), propyleneglycol monomethylether (PGME) and propyleneglycol monomethylether acetate (PGMEA), respectively to prepare solutions of photo-sensitive composition. Then the solutions were coated on a silicon wafer with a spinner and were dried at 110°C for 60 seconds to form 0.1 µm thick resist films.

The resist films were subjected to exposing with F2 excimer laser beam (wavelength: 157 nm) and after the exposing, the films were subjected to heating at 120°C for 60 seconds on a heated plate and then developing with an aqueous solution of tetramethylammonium hydroxide (TMAH) having a concentration of 2.38 % by weight.

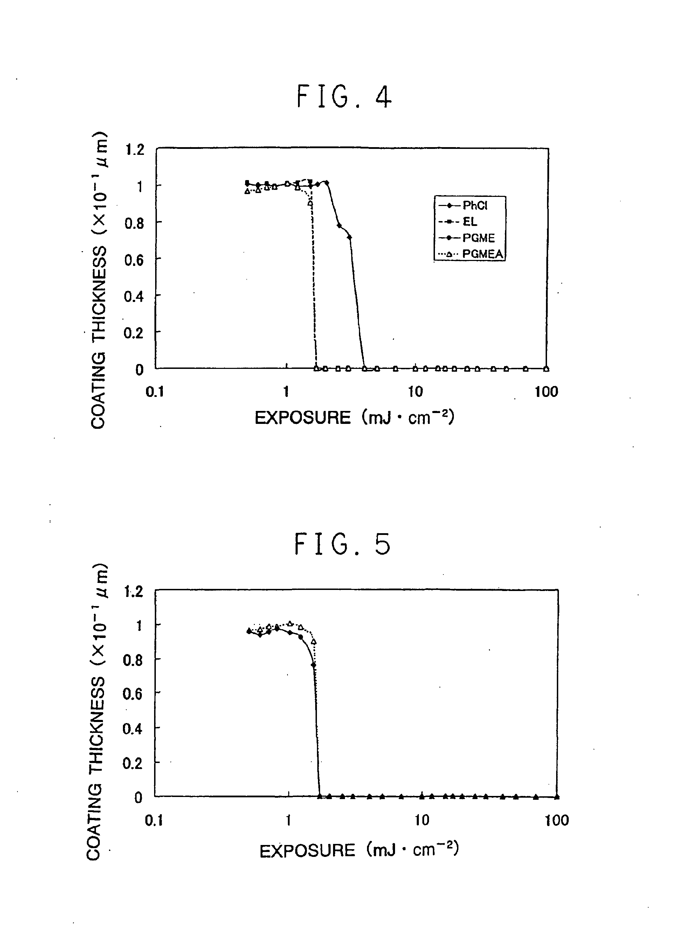

A thickness of the photo-sensitive composition film remaining after the developing is shown in Fig. 4.

In case of PGME, solubility of the photo-sensitive composition was low and there was a significant phase separation when the composition was coated on a substrate. In cases of using PGMEA and ethyl lactate as a solvent, a high sensitivity and good dissolution characteristics were exhibited.

### EXAMPLE 5

To 100 parts by weight of the fluorine-containing copolymer obtained in Preparation Example 5 was added 5 parts by weight of triphenylsulfonium triflate as a photoactive acid generator, followed by dissolving in PGMEA and further adding 0.05 part by weight of N-methylpyrrolidone thereto to prepare a solution of photo-sensitive composition. Then the solution was coated on a silicon wafer with a spinner and was dried at 110°C for 60 seconds to form a 0.1 µm thick resist film.

The resist film was subjected to exposing with F2 excimer laser beam (wavelength: 157 nm) and after the exposing, the film was subjected to heating at 120°C for 60 seconds on a heated plate and then developing with an aqueous solution of tetramethylammonium hydroxide (TMAH) having a concentration of 2.38 % by weight.

A thickness of the photo-sensitive composition film remaining after the developing is shown in Fig. 5.

### EXAMPLE 6

5 Parts by weight of triphenylsulfonium triflate as a photoactive acid generator was added to 100 parts by weight of the fluorine-containing copolymer obtained in Preparation Example 6 and to the copolymer obtained by dissociating a part of acid-labile groups of the polymer of Preparation Example 8 by the method of Preparation Example 7 and introducing 4 % by mole of carboxyl groups to the polymer, followed by dissolving the respective copolymers in PGMEA to prepare solutions of photo-sensitive composition. Then the solutions were coated on a silicon wafer with a spinner and were dried at 110°C for 60 seconds to form 0.1 µm thick resist films.

The resist films were subjected to exposing with F2 excimer laser beam (wavelength: 157 nm) and after the exposing, the films were subjected to heating at 120°C for 60 seconds on a heated plate and then developing with an aqueous solution of tetramethylammonium hydroxide (TMAH) having a concentration of 2.38 % by weight.

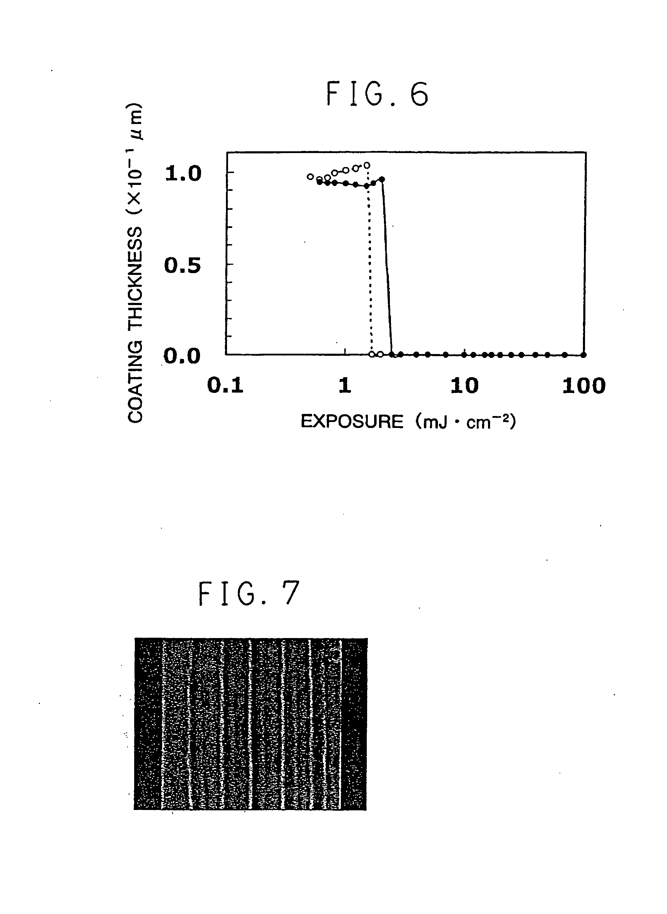

A thickness of the photo-sensitive composition film remaining after the developing is shown in Fig. 6.

With respect to the photo-sensitive composition prepared using the polymer of Preparation Example 9 subjected to deprotection and introduction of 18 % by mole of carboxyl groups, solubility in the developing solution was high and the whole film including the un-exposed area was dissolved in the developing solution. On the other hand, in case of the photo-sensitive composition obtained from the polymer containing no carboxyl group of Preparation Example 6, since there occurred a problem with the puddle formation due to repelling of the developing solution, uniformity of developing on the surface could not be maintained.

On the other hand, in case of the photo-sensitive composition obtained from the polymer of Preparation Example 7 to which 4 % by mole of carboxyl groups were introduced, good wettability of the developing solution was exhibited and puddle formation was good. The un-exposed area was insoluble in the developing solution.

### EXAMPLE 7

In PGMEA were dissolved 100 parts by weight of the fluorine-containing copolymer prepared in Preparation Example 7 and 5 parts by weight of triphenylsulfonium triflate as a photoactive acid generator to prepare a solution of photo-sensitive composition.

The solution was coated on a silicon wafer with a spinner and was dried at 110°C for 60 seconds to form a 0.1 µm thick resist film. A transmission of light at 157 nm through the resist film formed on an inorganic substrate under the same conditions was 35 %.

The resist film was subjected to exposing with a reduction projection exposure system using a F2 excimer laser beam (wavelength: 157 nm) as light source and after the exposing, the film was subjected to heating at 120°C for 60 seconds on a heated plate.

Then developing with an aqueous solution of tetramethylammonium hydroxide (TMAH) having a concentration of 2.38 % by weight was carried out. The exposed area of the resist film was selectively dissolved and removed and a fine pattern was formed.

A photograph of electron microscope of the obtained resist pattern having a line and space of 0.10 µm is shown in Fig. 7. As shown in Fig. 7, a cross-section of the pattern is good and the fine resist pattern could be formed at 23 mJ/cm². Namely, a remarkable resolution could be obtained as compared with a photo-sensitive composition of the following Comparative Example 2 prepared without using a fluorine-containing resin.

Also resist patterns having a line and space of 0.18 µm, 0.20 µm, 0.225 µm, 0.25 µm, 0.30 µm, 0.40 µm and 0.50 µm could be formed at 23 mJ/cm² using the photo-sensitive composition of this Example.

### COMPARATIVE EXAMPLE 2

In PGMEA were dissolved 100 parts by weight of a copolymer of 2MAdMA (2-methyl 2-adamantyl methacrylate) and MLMA (mevaloniclactone methacrylate) and 5 parts by weight of triphenylsulfonium triflate as a photoactive acid generator to prepare a solution of photo-sensitive composition.

The solution was coated on a silicon wafer with a spinner and was dried at 115°C for 60 seconds to form a 0.1 µm thick resist film. A transmittance of light at 157 nm through the resist film formed on an inorganic substrate by the same method was 12 %.

The resist film was subjected to exposing with a reduction projection exposure system using a F2 excimer laser beam (wavelength: 157 nm) as light source and after the exposing, the film was subjected to heating at 115°C for 60 seconds on a heated plate.

Then developing with an aqueous solution of tetramethylammonium hydroxide (TMAH) having a concentration of 2.38 % by weight was carried out. The exposed area of the resist film was selectively dissolved and removed but a shape of a 0.3 µm fine pattern was not rectangular.

With respect to a fine pattern thinner than 0.25 µm, only traces thereof could be recognized.

As mentioned above, in Comparative Example 2, it can be seen that the photo-sensitive composition prepared without using a fluorine-containing resin has a low transparency at 157 nm and a poor resolution.

### EXAMPLE 8

In PGMEA were dissolved 100 parts by weight of the fluorine-containing polymer prepared in Preparation Example 5 and 5 parts by weight of triphenylsulfonium triflate as a photoactive acid generator to prepare a solution of photo-sensitive composition.

The solution of photo-sensitive composition was coated, with a spinner, on a silicon wafer subjected to treatment with an adhesion improver and was dried at 115°C for 60 seconds to form a 0.1 µm thick resist film.

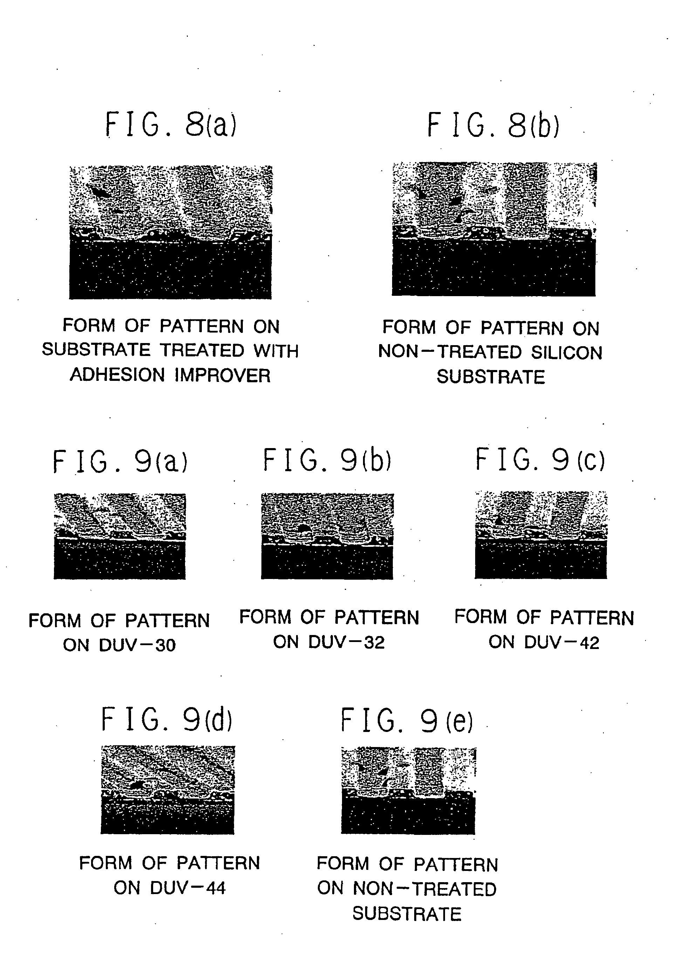

The resist film was subjected to exposing at 16 mJ·cm⁻² with a reduction projection exposure system using a F2 excimer laser beam (wavelength: 157 nm) as light source and after the exposing, the film was subjected to heating at 115°C for 60 seconds on a heated plate. Then developing with an aqueous solution of tetramethylammonium hydroxide (TMAH) having a concentration of 2.38 % by weight was carried out. Thus a pattern having a cross-section as shown on the left of Fig. 8 was obtained. The right side of Fig. 8 shows a cross-section of a fine pattern obtained when forming the pattern on a silicon substrate by the same method.

### EXAMPLE 9

In PGMEA were dissolved 100 parts by weight of the fluorine-containing polymer prepared in Preparation Example 5 and 5 parts by weight of triphenylsulfonium triflate as a photoactive acid generator to prepare a solution of photo-sensitive composition.

The solution of photo-sensitive composition was coated, with a spinner, on silicon wafers obtained by coating antireflection films of DUV-30, DUV-32, DUV-42 and DUV-44 available from Brewer Science Co., Ltd. and was dried at 115°C for 60 seconds to form 0.1 µm thick resist films.

The resist films were subjected to exposing at 18 mJ-cm⁻² with a reduction projection exposure system using a F2 excimer laser beam (wavelength: 157 nm) as light source and after the exposing, the films were subjected to heating at 115°C for 60 seconds on a heated plate. Then developing with an aqueous solution of tetramethylammonium hydroxide (TMAH) having a concentration of 2.38 % by weight was carried out. Thus patterns having a cross-section as shown in Fig. 9 were obtained. Fig. 9(e) shows a cross-section of a fine pattern obtained when forming the pattern on a silicon substrate by the same method.

### INDUSTRIAL APPLICABILITY

As explained above, according to the present invention, a precise fine pattern can be formed by forming, on a substrate or on a given layer thereon, a photo-sensitive layer mainly comprising a photo-sensitive composition containing a material having a small absorption of exposure light having a short wavelength such as F2 excimer laser beam and an acid generator generating an acid by irradiation of light having a short wavelength such as F2 excimer laser beam; irradiating the given area of the photo-sensitive layer selectively with light having a short wavelength such as F2 excimer laser beam for exposing; heat-treating the exposed photo-sensitive layer; and then developing the heat-treated photo-sensitive layer to selectively remove the exposed area or un-exposed area of the photo-sensitive layer.

Also electronic devices such as a semiconductor device having a fine pattern can be produced by etching a substrate layer under the so-obtained fine pattern using the fine pattern as a mask.

Further in the method of forming a fine pattern of the present invention, as explained above, when light having a short wavelength, particularly F2 excimer laser beam is used as exposure light, a resolution of the photo-sensitive composition is significantly increased as compared with that of conventional composition and therefore a high performance of a semiconductor device can be obtained since a density thereof is made high, which gives rise to a remarkable industrial value.

## Claims

1. A method of forming a fine resist pattern comprising, a step for forming a photo-sensitive layer on a substrate or a given layer on a substrate by using a photo-sensitive composition comprising at least a compound generating an acid by irradiation of light and a compound having fluorine atom in its molecular structure, a step for exposing by selectively irradiating a given area of said photo-sensitive layer with energy ray, a step for heat-treating said exposed photo-sensitive layer, and a step for forming a fine pattern by developing said heat-treated photo-sensitive layer to selectively remove the exposed portion or un-exposed portion of said photo-sensitive layer.

2. The method of forming a fine resist pattern of Claim 1, wherein said compound having fluorine atom is a fluorine-containing copolymer having a ring structure in its trunk chain and acid-labile functional groups which are converted to carboxyl due to action of an acid, said fluorine-containing copolymer is represented by the formula (1):
-(M1)-(M2)-(M3)-(A1)- (1)
wherein the structural unit M1 is a structural unit derived from an ethylenic monomer having 2 or 3 carbon atoms and at least one fluorine atom,
the structural unit M2 is a structural unit derived from a cyclic aliphatic unsaturated hydrocarbon which is copolymerizable with M 1 and may be subjected to replacing with fluorine atom,
the structural unit M3 is represented by: 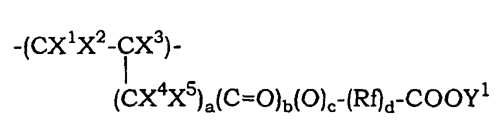 wherein Y¹ is an acid-labile functional group; X¹ and X² are the same or different and each is H or F; X³ is H, F, Cl, CH₃ or CF₃; X⁴ and X⁵ are the same or different and each is H, F or CF₃; Rf is a fluorine-containing alkylene group having 1 to 40 carbon atoms or a fluorine-containing alkylene group having 2 to 100 carbon atoms and ether bond; a is 0 or an integer of from 1 to 3; b, c and d are the same or different and each is 0 or 1,
the structural unit A1 is a structural unit derived from monomer copolymerizable with (M1), (M2) and (M3), and
M1, M2, M3 and A1 are contained in amounts of from 5 to 70 % by mole, from 5 to 70 % by mole, from 5 to 75 % by mole and from 0 to 50 % by mole, respectively.

3. The method of forming a fine resist pattern of Claim 1, wherein said compound having fluorine atom is a fluorine-containing copolymer having a ring structure in its trunk chain and acid-labile functional groups which are converted to carboxyl due to action of an acid, said fluorine-containing copolymer is represented by the formula (2):
-(M1)-(M4)-(A2)- (2)
wherein the structural unit M1 is a structural unit derived from an ethylenic monomer having 2 or 3 carbon atoms and at least one fluorine atom,
the structural unit M4 is a structural unit derived from a monomer of a cyclic aliphatic unsaturated hydrocarbon which is copolymerizable with M1, may be subjected to replacing with fluorine atom and has an acid-labile functional group Y²,
the structural unit A2 is a structural unit derived from monomer copolymerizable with (M1) and (M4), and
M1, M4 and A2 are contained in amounts of from 5 to 70 % by mole, from 5 to 60 % by mole and from 0 to 50 % by mole, respectively.

4. The method of forming a fine resist pattern of Claim 2 or 3, wherein said acid-labile functional groups Y¹ and Y² are -C(CH₃)₃.

5. The method of forming a fine resist pattern of any of Claims 2 to 4, wherein the structural unit having the acid-labile functional groups is contained in an amount of not less than 15 % by mole based on the whole structural units constituting the fluorine-containing copolymer.

6. The method of forming a fine resist pattern of any of Claims 2 to 5, wherein the fluorine-containing copolymer having the acid-labile functional groups is a fluorine-containing copolymer having the acid-labile functional groups partly dissociated and converted to carboxyl.

7. The method of forming a fine resist pattern of Claim 6, wherein the fluorine-containing copolymer having the acid-labile functional groups is a fluorine-containing copolymer having the acid-labile functional groups partly dissociated and converted to carboxyl and containing carboxyl in an amount of not less than 1 % by mole and less than 15 % by mole based on the whole structural units constituting the fluorine-containing copolymer.

8. The method of forming a fine resist pattern of any of Claims 1 to 7, wherein F₂ excimer laser beam is used as said energy ray.

9. The method of forming a fine resist pattern of any of Claims 1 to 7, wherein ArF excimer laser beam is used as said energy ray.

10. The method of forming a fine resist pattern of any of Claims 1 to 7, wherein KrF excimer laser beam is used as said energy ray.

11. The method of forming a fine resist pattern of any of Claims 1 to 7, wherein high energy electron beam is used as said energy ray.

12. The method of forming a fine resist pattern of any of Claims 1 to 7, wherein high energy ion beam is used as said energy ray.

13. The method of forming a fine resist pattern of any of Claims 1 to 7, wherein X-ray is used as said energy ray.

14. The method of forming a fine resist pattern of any of Claims 1 to 13, wherein the photo-sensitive composition which is used for forming the fine resist pattern is coated on a substrate in the form of propylene glycol monomethyl ether acetate (PGMEA) solution.

15. The method of forming a fine resist pattern of any of Claims 1 to 13, wherein the photo-sensitive composition which is used for forming the fine resist pattern is coated on a substrate in the form of ethyl lactate solution.

16. A method of forming a fine circuit pattern comprising, steps for forming a fine resist pattern by the method of any of Claims 1 to 15 on a substrate or on a given layer on a substrate, and thereafter a step for forming an intended circuit pattern by etching said substrate or said given layer through the fine resist pattern.
